# EUROPEAN PATENT APPLICATION

(11) **EP 4 307 049 A1**
(43) Date of publication of application: **17.01.2024**
(21) Application number: 22767081.7
(22) Date of filing: 07.03.2022
(51) Int. Cl.: G03F 7/004, G03F 7/027, G03F 7/033

(54) **PHOTOSENSITIVE FILM, PHOTOSENSITIVE ELEMENT, AND PRODUCTION METHOD FOR LAYERED PRODUCT**

(30) Priority: 09.03.2021 WO PCT/JP2021/009276; 05.08.2021 WO PCT/JP2021/029189
(71) Applicant: RESONAC CORPORATION, Tokyo 1058518 (JP)
(72) Inventor: NARITA, Mao, Tokyo 105-8518 (JP); ONO, Keishi, Tokyo 105-8518 (JP); TANAKA, Shiho, Tokyo 105-8518 (JP); TAKEDA, Akiko, Tokyo 105-8518 (JP); WATANABE, Yusaku, Tokyo 105-8518 (JP)
(74) Representative: Berggren Oy
(86) International application number: PCT/JP2022/009697
(87) International publication number: WO 2022/191125

(57) **Abstract**

A photosensitive film containing (A) a binder polymer, (B) a photopolymerizable compound, (C) a photopolymerization initiator, and (D) a pyrazoline compound, in which a thickness of the photosensitive film is 20 µm or less. A photosensitive element 1 including a support 2, and a photosensitive resin layer 3 disposed on the support 2, in which the photosensitive resin layer 3 is the photosensitive film. A method for producing a laminate, the method including a disposing step of disposing a photosensitive resin layer on a base material by using the above-described photosensitive film or the photosensitive element 1, a step of photo-curing a part of the photosensitive resin layer, and a step of removing at least a part of an uncured area of the photosensitive resin layer to form a cured product pattern.

## Description

### Technical Field

The present disclosure relates to a photosensitive film, a photosensitive element, a method for producing a laminate, and the like.

### Background Art

In the production of laminates that can be used as wiring boards and the like, resist patterns are formed in order to obtain desired wirings. The resist pattern can be formed by exposing and developing a photosensitive film that is a film-shaped photosensitive resin composition. As the photosensitive resin composition, various compositions have been investigated. For example, Patent Literature 1 below describes a photosensitive resin composition containing a binder polymer, a photopolymerizable compound, and a specific photopolymerization initiator.

### Citation List

### Patent Literature

Patent Literature 1: Japanese Unexamined Patent Publication No. 2019-028398

### Summary of Invention

### Technical Problem

When a cured product pattern that can be used as a resist pattern is formed by using a photosensitive film, the cured product pattern is formed while a photosensitive resin composition is filled in a recessed portion having a circular cross-section (circular hole) in some cases. However, in a conventional photosensitive film, a cured product pattern is formed in a state where a void is generated in a recessed portion, and followability (fillability) with respect to the shape of the recessed portion is not sufficient, in some cases. Furthermore, conventionally, although a photosensitive film having a thickness of 25 µm is usually used, it is required to reduce the thickness of the photosensitive film to 20 µm or less for the purpose of reducing the thickness of a laminate, or the like, in some cases. However, when the thickness of the photosensitive film is reduced in this way, the amount of the photosensitive resin composition for filling the recessed portion is decreased, and thus a cured product pattern is likely to be formed in a state where a void is generated in the recessed portion. Therefore, the photosensitive film is required to have excellent followability with respect to the recessed portion having a circular cross-section even in a case where the thickness of the photosensitive film is 20 µm or less.

An object of an aspect of the present disclosure is to provide a photosensitive film having excellent followability with respect to a recessed portion having a circular cross-section as a photosensitive film having a thickness of 20 µm or less. An object of another aspect of the present disclosure is to provide a photosensitive element using this photosensitive film. An object of still another aspect of the present disclosure is to provide a method for producing a laminate using the above-described photosensitive film or photosensitive element.

### Solution to Problem

An aspect of the present disclosure relates to a photosensitive film containing (A) a binder polymer, (B) a photopolymerizable compound, (C) a photopolymerization initiator, and (D) a pyrazoline compound, in which a thickness of the photosensitive film is 20 µm or less.

Such a photosensitive film has excellent followability with respect to a recessed portion having a circular cross-section although the thickness of the photosensitive film is 20 µm or less.

Another aspect of the present disclosure relates to a photosensitive element including a support, and a photosensitive resin layer disposed on the support, in which the photosensitive resin layer is the above-described photosensitive film.

Still another aspect of the present disclosure relates to a method for producing a laminate, the method including a disposing step of disposing a photosensitive resin layer on a base material by using the above-described photosensitive film or the above-described photosensitive element, a step of photo-curing a part of the photosensitive resin layer, and a step of removing at least a part of an uncured area of the photosensitive resin layer to form a cured product pattern.

### Advantageous Effects of Invention

According to an aspect of the present disclosure, it is possible to provide a photosensitive film having excellent followability with respect to a recessed portion having a circular cross-section as a photosensitive film having a thickness of 20 µm or less. According to another aspect of the present disclosure, it is possible to provide a photosensitive element using this photosensitive film. According to still another aspect of the present disclosure, it is possible to provide a method for producing a laminate using the above-described photosensitive film or photosensitive element.

### Brief Description of Drawings

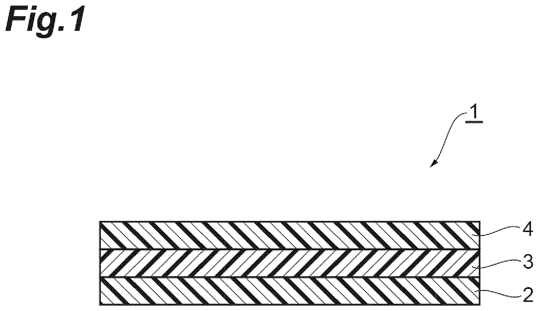

FIG. 1 is a schematic cross-sectional view illustrating an example of a photosensitive element.

### Description of Embodiments

Hereinafter, embodiments of the present disclosure will be described in detail. However, the present disclosure is not limited to the following embodiments.

In the present specification, a numerical range that has been indicated by use of "to" indicates the range that includes the numerical values which are described before and after "to", as the minimum value and the maximum value, respectively. The numerical range "A or more" means A and a range of more than A. The numerical range "A or less" means A and a range of less than A. In the numerical ranges that are described stepwise in the present specification, the upper limit value or the lower limit value of the numerical range of a certain stage can be arbitrarily combined with the upper limit value or the lower limit value of the numerical range of another stage. In a numerical range described in the present specification, the upper limit value or the lower limit value of the numerical range may be substituted by a value shown in Examples. "A or B" may include either one of A and B, and may also include both of A and B. Materials listed as examples in the present specification can be used singly or in combinations of two or more kinds, unless otherwise specified. When a plurality of substances corresponding to each component exist in the composition, the content of each component in the composition means the total amount of the plurality of substances that exist in the composition, unless otherwise specified. The term "layer" includes a structure having a shape which is formed on a part, in addition to a structure having a shape which is formed on the whole surface, when the layer has been observed as a plan view. The term "step" includes not only an independent step but also a step by which an intended action of the step is achieved, even though the step cannot be clearly distinguished from other steps. The term "(meth)acrylate" means at least one of "acrylate" and "methacrylate" corresponding thereto. The same applies to other analogous expressions such as "(meth)acrylic acid". The "alkyl group" may be linear, branched, or cyclic, unless otherwise specified.

In the present specification, the solid content of a photosensitive resin composition refers to a non-volatile content of a photosensitive resin composition excluding volatile substances (such as water and a solvent). That is, the solid content refers to a component remaining without volatile in drying of the photosensitive resin composition (a component other than a solvent) and also includes a component in a liquid, syrupy, or waxy state at room temperature (25°C).

### <Photosensitive film and photosensitive resin composition>

A photosensitive film of the present embodiment contains (A) a binder polymer, (B) a photopolymerizable compound, (C) a photopolymerization initiator, and (D) a pyrazoline compound, in which a thickness of the photosensitive film is 20 µm or less. The photosensitive film of the present embodiment is a photosensitive resin composition having a film shape, and can be obtained by molding a photosensitive resin composition of the present embodiment into a film shape. The photosensitive resin composition of the present embodiment can contain the same components as those contained in the photosensitive film of the present embodiment.

Although the thickness of the photosensitive film of the present embodiment is 20 µm or less, the photosensitive film has excellent followability (circular hole followability, fillability) with respect to a recessed portion (for example, a diameter of 200 µm and a depth of 8 µm) having a circular cross-section (for example, substantially true circle). According to the photosensitive film of the present embodiment, in evaluation described in Examples, for example, followability of less than 20000 µm² (preferably 15000 µm² or less) can be obtained.

The present inventors have speculated factors for excellent followability obtained by the photosensitive film and the photosensitive resin composition of the present embodiment as follows. However, the factors are not limited to the contents to be as follows. That is, by using the component (D) when the component (A), the component (B), and the component (C) are used in combination, various physical properties (such as crystallinity and a melting point) of the component (D) suitably acts in a thermal process (such as lamination) when the photosensitive film is laminated on the base material with a recessed portion having a circular cross-section. Thus, since flowability suitable in the thermal process is easily obtained, excellent followability is obtained even when the thickness of the photosensitive film is 20 µm or less (even when the amount of the photosensitive resin composition for filling the recessed portion is small).

The photosensitive film of the present embodiment is sufficient to have excellent followability when the photosensitive film is laminated on the base material with a recessed portion having a circular cross-section, and may be laminated on a base material with a recessed portion having a cross-sectional shape different from a circular shape, a base material having no recessed portion, or the like.

Incidentally, when a cured product pattern that can be used as a resist pattern is formed by using the photosensitive film or the photosensitive resin composition, a cured product pattern having a straight line area and a straight space area adjacent to the line area is formed in some cases. Further, in the case of forming a cured product pattern having a width of the space area (space width) smaller than a width of the line area (line width), excellent resolution is required as a property with which the line area and the space area are favorably formed, in some cases. Furthermore, in the case of forming a cured product pattern having a line width smaller than a space width, excellent adhesiveness is required as a property with which the line area and the space area are favorably formed, in some cases.

According to the photosensitive film or the photosensitive resin composition of the present embodiment, it is possible to obtain excellent resolution in the case of forming a cured product pattern having a space width smaller than a line width. According to the photosensitive film of the present embodiment, in evaluation described in Examples, for example, resolution of 15 µm or less can be obtained.

According to the photosensitive film or the photosensitive resin composition of the present embodiment, it is possible to obtain excellent adhesiveness in the case of forming a cured product pattern having a line width smaller than a space width. According to the photosensitive film and the photosensitive resin composition of the present embodiment, in evaluation described in Examples, for example, adhesiveness of 10 µm or less can be obtained.

According to the photosensitive film or the photosensitive resin composition of the present embodiment, the minimal time for removing an unexposed area can be reduced, and excellent developability can be obtained.

According to the photosensitive film and the photosensitive resin composition of the present embodiment, excellent sensitivity (before temporal change) with respect to an active light ray can be obtained. According to the photosensitive film and the photosensitive resin composition of the present embodiment, in evaluation described in Examples, for example, an exposure dose of 105 mJ/cm² or less can be obtained.

The photosensitive film and the photosensitive resin composition of the present embodiment have photo-curability and a cured product can be obtained by photo-curing this photosensitive film or the photosensitive resin composition. A cured product of the present embodiment is a cured product (photo-cured product) of the photosensitive film or the photosensitive resin composition of the present embodiment. The cured product of the present embodiment may have a patterned shape (cured product pattern), and may be a resist pattern. The shape of a cured product pattern that can be obtained by the photosensitive film and the photosensitive resin composition of the present embodiment is not particularly limited.

The thickness of the photosensitive film of the present embodiment is 20 µm or less, and the thickness of the cured product of the present embodiment may be 20 µm or less. The thickness of each of the photosensitive film and the cured product of the present embodiment may be 1 µm or more, 3 µm or more, 5 µm or more, more than 5 µm, 7 µm or more, more than 7 µm, 8 µm or more, 10 µm or more, more than 10 µm, 15 µm or more, 18 µm or more, or 19 µm or more, from the viewpoint of easily obtaining excellent followability and the viewpoint of easily obtaining a resist pattern having a sufficient thickness. The thickness of each of the photosensitive film and the cured product of the present embodiment may be 19 µm or less from the viewpoint of easily obtaining excellent resolution and adhesiveness. From these viewpoints, the thickness of each of the photosensitive film and the cured product of the present embodiment may be 1 to 20 µm, 5 to 20 µm, or 15 to 20 µm. The thickness of each of the photosensitive film and the cured product may be an average thickness of ten places thereof.

In the photosensitive film and the photosensitive resin composition of the present embodiment, a wavelength at which photosensitivity is exhibited is not particularly limited. The photosensitive film and the photosensitive resin composition of the present embodiment may have, for example, photosensitivity with respect to light having a wavelength of 300 nm or more, 340 nm or more, 350 nm or more, 355 nm or more, 365 nm or more, 375 nm or more, 390 nm or more, 395 nm or more, or 405 nm or more. The photosensitive film and the photosensitive resin composition of the present embodiment may have, for example, photosensitivity with respect to light having a wavelength of 500 nm or less, 440 nm or less, less than 440 nm, 436 nm or less, 420 nm or less, 410 nm or less, or 405 nm or less. In an exposure step described below, an active light ray having a peak within these wavelength ranges can be used. The photosensitive film and the photosensitive resin composition of the present embodiment can be used, for example, as a negative-type photosensitive film and photosensitive resin composition.

According to the present embodiment, it is possible to provide the application of the photosensitive resin composition, the photosensitive film, or the photosensitive element for forming a cured product pattern (for example, a resist pattern). According to the present embodiment, it is possible to provide the application of the photosensitive resin composition, the photosensitive film, or the photosensitive element for manufacturing a wiring board.

The photosensitive film and the photosensitive resin composition of the present embodiment contain a binder polymer as the component (A). Examples of the component (A) include an acrylic resin, a styrene-based resin, an epoxy-based resin, an amide-based resin, an amide-epoxy-based resin, an alkyd-based resin, and a phenol-based resin. The acrylic resin is a resin that has a compound having a (meth)acryloyl group ((meth)acrylic acid compound) as a monomer unit, and a styrene-based resin, an epoxy-based resin, an amide-based resin, an amide-epoxy-based resin, an alkyd-based resin, and a phenol-based resin that have this monomer unit attribute to the acrylic resin. The component (A) may include a binder polymer not having a phenolic hydroxyl group, and may not include a binder polymer having a phenolic hydroxyl group.

The component (A) may include an acrylic resin from the viewpoint of easily obtaining excellent followability, resolution, and adhesiveness. The content of the acrylic resin may be 50% by mass or more, more than 50% by mass, 70% by mass or more, 90% by mass or more, 95% by mass or more, 98% by mass or more, 99% by mass or more, or substantially 100% by mass (an embodiment in which the component (A) is substantially composed of the acrylic resin), on the basis of the total mass of the component (A), from the viewpoint of easily obtaining excellent followability, resolution, and adhesiveness.

Examples of the compound having a (meth)acryloyl group include a (meth)acrylic acid and a (meth)acrylic acid ester. Examples of the (meth)acrylic acid ester include alkyl (meth)acrylate (alkyl (meth)acrylate ester; excluding a compound corresponding to cycloalkyl (meth)acrylate), cycloalkyl (meth)acrylate (cycloalkyl (meth)acrylate ester), aryl (meth)acrylate (aryl (meth)acrylate ester), a (meth)acrylamide compound (such as diacetone acrylamide), glycidyl (meth)acrylate ester, and styryl (meth)acrylate.

The component (A) may have a (meth)acrylic acid as a monomer unit from the viewpoint of easily obtaining excellent followability, resolution, and adhesiveness. In a case where the component (A) has a (meth)acrylic acid as a monomer unit, the content of the monomer unit of the (meth)acrylic acid may be in the following range on the basis of the total amount of monomer units constituting the component (A), from the viewpoint of easily obtaining excellent followability, resolution, and adhesiveness. The content of the monomer unit of the (meth)acrylic acid may be 1% by mass or more, 5% by mass or more, 10% by mass or more, 12% by mass or more, 15% by mass or more, 18% by mass or more, 20% by mass or more, 23% by mass or more, 25% by mass or more, or 27% by mass or more. The content of the monomer unit of the (meth)acrylic acid may be 50% by mass or less, less than 50% by mass, 45% by mass or less, 40% by mass or less, 37% by mass or less, 35% by mass or less, 32% by mass or less, 30% by mass or less, or 27% by mass or less. From these viewpoints, the content of the monomer unit of the (meth)acrylic acid may be 1 to 50% by mass.

The component (A) may have alkyl (meth)acrylate as a monomer unit from the viewpoint of easily obtaining excellent followability, resolution, and adhesiveness. Examples of the alkyl group of the alkyl (meth)acrylate include a methyl group, an ethyl group, a propyl group, a butyl group, a pentyl group, a hexyl group, a heptyl group, an octyl group, a nonyl group, a decyl group, an undecyl group, and a dodecyl group, and the alkyl group may be various structural isomers. The number of carbon atoms of the alkyl group of the alkyl (meth)acrylate may be 1 to 4, 1 to 3, 2 to 3, or 1 to 2, from the viewpoint of easily obtaining excellent followability, resolution, and adhesiveness.

The alkyl group of the alkyl (meth)acrylate may have a substituent. Examples of the substituent include a hydroxy group, a carboxy group, a carboxylate group, an aldehyde group, an alkoxy group (an unsubstituted alkoxy group (a structure having an unsubstituted alkyl group bonded to an oxygen atom), or substituted alkoxy group (such as a hydroxyalkoxy group)), a carbonyl group, an alkoxycarbonyl group, an alkanoyl group (such as an alkanoyl group having 2 to 12 carbon atoms), an oxycarbonyl group, a carbonyloxy group, an amino group, an epoxy group, a furyl group, a cyano group, a halogeno group (such as a fluoro group, a chloro group, or a bromo group), a nitro group, an acetyl group, a sulfonyl group, and a sulfonamide group. Examples of the alkyl (meth)acrylate include dimethylaminoethyl (meth)acrylate, diethylaminoethyl (meth)acrylate, 2,2,2-trifluoroethyl (meth)acrylate, 2,2,3,3-tetrafluoropropyl (meth)acrylate, α-chloro (meth)acrylic acid, and α-bromo (meth)acrylic acid.

The component (A) may have hydroxyalkyl (meth)acrylate as a monomer unit from the viewpoint of easily obtaining excellent followability, resolution, and adhesiveness. Examples of the hydroxyalkyl (meth)acrylate include hydroxymethyl (meth)acrylate, hydroxyethyl (meth)acrylate, hydroxypropyl (meth)acrylate, hydroxybutyl (meth) acrylate, hydroxypentyl (meth) acrylate, and hydroxyhexyl (meth)acrylate.

The content of the monomer unit of alkyl (meth)acrylate in a case where the component (A) has alkyl (meth)acrylate as a monomer unit or the content of the monomer unit of hydroxyalkyl (meth)acrylate in a case where the component (A) has hydroxyalkyl (meth)acrylate as a monomer unit may be in the following range on the basis of the total amount of monomer units constituting the component (A). The content of the above-described monomer unit may be 0.10% by mass or more, 0.50% by mass or more, 1.0% by mass or more, 1.5% by mass or more, 2.0% by mass or more, 2.5% by mass or more, or 3.0% by mass or more, from the viewpoint of easily obtaining excellent followability, resolution, and adhesiveness. The content of the above-described monomer unit may be 3.5% by mass or more, 4.0% by mass or more, 4.5% by mass or more, or 5.0% by mass or more, from the viewpoint of easily obtaining excellent sensitivity and developability and the viewpoint of easily obtaining further excellent followability. The content of the above-described monomer unit may be 20% by mass or less, 18% by mass or less, 15% by mass or less, 12% by mass or less, 10% by mass or less, 8.0% by mass or less, 6.0% by mass or less, 5.5% by mass or less, or 5.0% by mass or less, from the viewpoint of easily obtaining excellent followability, resolution, and adhesiveness. The content of the above-described monomer unit may be 4.5% by mass or less, 4.0% by mass or less, 3.5% by mass or less, or 3.0% by mass or less, from the viewpoint of easily obtaining further excellent resolution. From these viewpoints, the content of the above-described monomer unit may be 0.10 to 20% by mass or 0.10 to 5.0% by mass.

In the component (A) contained in the photosensitive film and the photosensitive resin composition of the present embodiment, the content of the monomer unit of alkyl (meth)acrylate in which the number of carbon atoms of the alkyl group is 4 or more may be 1% by mass or less, less than 1% by mass, 0.1% by mass or less, or 0.01% by mass or less, on the basis of the total amount of monomer units constituting the component (A).

The component (A) may have aryl (meth)acrylate as a monomer unit from the viewpoint of easily obtaining excellent followability, resolution, and adhesiveness. Examples of the aryl (meth)acrylate include benzyl (meth)acrylate, phenyl (meth)acrylate, and naphthyl (meth)acrylate.

In a case where the component (A) has aryl (meth)acrylate as a monomer unit, the content of the monomer unit of the aryl (meth)acrylate may be in the following range on the basis of the total amount of monomer units constituting the component (A). The content of the monomer unit of the aryl (meth)acrylate may be 1% by mass or more, 5% by mass or more, 10% by mass or more, 12% by mass or more, 15% by mass or more, 18% by mass or more, or 20% by mass or more, from the viewpoint of easily obtaining excellent followability, resolution, and adhesiveness. The content of the monomer unit of the aryl (meth)acrylate may be 21% by mass or more or 23% by mass or more, from the viewpoint of easily obtaining excellent sensitivity and developability and the viewpoint of easily obtaining further excellent followability. The content of the monomer unit of the aryl (meth)acrylate may be 50% by mass or less, less than 50% by mass, 45% by mass or less, 40% by mass or less, 35% by mass or less, 30% by mass or less, 25% by mass or less, or 23% by mass or less, from the viewpoint of easily obtaining excellent followability, resolution, and adhesiveness. The content of the monomer unit of the aryl (meth)acrylate may be 21% by mass or less or 20% by mass or less, from the viewpoint of easily obtaining further excellent resolution. From these viewpoints, the content of the monomer unit of the aryl (meth)acrylate may be 1 to 50% by mass.

The component (A) may have a styrene compound (excluding a compound having a (meth)acryloyl group) as a monomer unit from the viewpoint of easily obtaining excellent followability, resolution, and adhesiveness. Examples of the styrene compound include styrene and a styrene derivative. Examples of the styrene derivative include vinyl toluene and α-methylstyrene. From the viewpoint of easily obtaining excellent followability, resolution, and adhesiveness, the component (A) may have a (meth)acrylic acid and a styrene compound as monomer units, may have hydroxyalkyl (meth)acrylate and a styrene compound as monomer units, and may have aryl (meth)acrylate and a styrene compound as monomer units.

In a case where the component (A) has a styrene compound as a monomer unit, the content of the monomer unit of the styrene compound may be in the following range on the basis of the total amount of monomer units constituting the component (A). The content of the monomer unit of the styrene compound may be 10% by mass or more, 15% by mass or more, more than 15% by mass, 20% by mass or more, 25% by mass or more, 30% by mass or more, more than 30% by mass, 35% by mass or more, 40% by mass or more, or 45% by mass or more, from the viewpoint of easily obtaining excellent followability, resolution, and adhesiveness. The content of the monomer unit of the styrene compound may be 47% by mass or more or 50% by mass or more, from the viewpoint of easily obtaining further excellent resolution. The content of the monomer unit of the styrene compound may be 90% by mass or less, 85% by mass or less, 80% by mass or less, 75% by mass or less, 70% by mass or less, 65% by mass or less, less than 65% by mass, 60% by mass or less, 55% by mass or less, or 50% by mass or less, from the viewpoint of easily obtaining excellent followability, resolution, and adhesiveness. The content of the monomer unit of the styrene compound may be 47% by mass or less or 45% by mass or less, from the viewpoint of easily obtaining excellent sensitivity and developability and the viewpoint of easily obtaining further excellent followability. From these viewpoints, the content of the monomer unit of the styrene compound may be 10 to 90% by mass.

The component (A) may have other monomer as a monomer unit. Examples of such monomer include ethers of vinyl alcohol (such as vinyl-n-butyl ether), (meth)acrylonitrile, maleic acid, maleic anhydride, maleic acid monoesters (such as monomethyl maleate, monoethyl maleate, and monoisopropyl maleate), fumaric acid, cinnamic acid, α-cyanocinnamic acid, itaconic acid, crotonic acid, and propiolic acid.

The acid value of the component (A) may be 80 mgKOH/g or more, 90 mgKOH/g or more, 100 mgKOH/g or more, more than 100 mgKOH/g, 120 mgKOH/g or more, 140 mgKOH/g or more, 150 mgKOH/g or more, 160 mgKOH/g or more, 170 mgKOH/g or more, or 175 mgKOH/g or more, from the viewpoint of easily obtaining excellent sensitivity, developability, followability, resolution, and adhesiveness. The acid value of the component (A) may be 176 mgKOH/g or more from the viewpoint of easily obtaining further excellent resolution. The acid value of the component (A) may be 250 mgKOH/g or less, 240 mgKOH/g or less, 230 mgKOH/g or less, 210 mgKOH/g or less, 200 mgKOH/g or less, 180 mgKOH/g or less, 178 mgKOH/g or less, or 176 mgKOH/g or less, from the viewpoint of easily obtaining excellent sensitivity, developability, followability, resolution, and adhesiveness. The acid value of the component (A) may be 175 mgKOH/g or less from the viewpoint of easily obtaining further excellent sensitivity, developability, and followability. From these viewpoints, the acid value of the component (A) may be 80 to 250 mgKOH/g. The acid value of the component (A) can be adjusted by the content of monomer units (for example, the monomer unit of the (meth)acrylic acid) constituting the component (A). The acid value of the component (A) can be measured by the method described in Examples.

The weight average molecular weight (Mw) of the component (A) may be in the following range from the viewpoint of easily obtaining excellent sensitivity, developability, followability, resolution, and adhesiveness. The weight average molecular weight of the component (A) may be 10000 or more, 20000 or more, 25000 or more, 30000 or more, or 35000 or more. The weight average molecular weight of the component (A) may be 100000 or less, 80000 or less, 70000 or less, less than 70000, 65000 or less, 60000 or less, 50000 or less, 40000 or less, or 35000 or less. From these viewpoints, the weight average molecular weight of the component (A) may be 10000 to 100000, 20000 to 50000, or 30000 to 40000.

The number average molecular weight (Mn) of the component (A) may be in the following range. The number average molecular weight of the component (A) may be 5000 or more, 10000 or more, 12000 or more, 15000 or more, or 16000 or more, from the viewpoint of easily obtaining excellent sensitivity, developability, followability, resolution, and adhesiveness. The number average molecular weight of the component (A) may be 16500 or more from the viewpoint of easily obtaining further excellent sensitivity, developability, and followability. The number average molecular weight of the component (A) may be 50000 or less, 40000 or less, 35000 or less, 30000 or less, 25000 or less, 20000 or less, 18000 or less, 17000 or less, or 16500 or less, from the viewpoint of easily obtaining excellent sensitivity, developability, followability, resolution, and adhesiveness. The number average molecular weight of the component (A) may be 16000 or less from the viewpoint of easily obtaining further excellent resolution. From these viewpoints, the number average molecular weight of the component (A) may be 5000 to 50000, 10000 to 25000, or 15000 to 20000.

The degree of dispersion (weight average molecular weight/number average molecular weight) of the component (A) may be in the following range. The degree of dispersion of the component (A) may be 1.00 or more, 1.50 or more, 1.80 or more, 2.00 or more, 2.10 or more, or 2.12 or more, from the viewpoint of easily obtaining excellent sensitivity, developability, followability, resolution, and adhesiveness. The degree of dispersion of the component (A) may be 2.15 or more or 2.18 or more, from the viewpoint of easily obtaining further excellent resolution. The degree of dispersion of the component (A) may be 3.00 or less, 2.80 or less, 2.50 or less, 2.30 or less, or 2.20 or less, from the viewpoint of easily obtaining excellent sensitivity, developability, followability, resolution, and adhesiveness. The degree of dispersion of the component (A) may be 2.18 or less or 2.15 or less, from the viewpoint of easily obtaining further excellent sensitivity, developability, and followability. From these viewpoints, the degree of dispersion of the component (A) may be 1.00 to 3.00.

The weight average molecular weight and the number average molecular weight can be measured, for example, by gel permeation chromatography (GPC) using a calibration curve of standard polystyrene. More specifically, it is possible to measure under conditions described in Examples. As for a compound having a low molecular weight, in a case where measurement of the weight average molecular weight and the number average molecular weight is difficult using the above-described measurement method, it is also possible to measure the molecular weights using other methods and to calculate an average value thereof.

The content of the component (A) may be in the following range on the basis of the total amount of the photosensitive film or the total amount (the total amount of solid contents) of the photosensitive resin composition. The content of the component (A) may be 10% by mass or more, 20% by mass or more, 30% by mass or more, 40% by mass or more, 45% by mass or more, or 50% by mass or more, from the viewpoint of easily obtaining excellent followability, resolution, and adhesiveness and the viewpoint of having excellent film moldability. The content of the component (A) may be 90% by mass or less, 80% by mass or less, 75% by mass or less, 70% by mass or less, 65% by mass or less, 60% by mass or less, or 55% by mass or less, from the viewpoint of easily obtaining excellent followability, resolution, and adhesiveness. From these viewpoints, the content of the component (A) may be 10 to 90% by mass.

The content of the component (A) may be in the following range with respect to 100 parts by mass of the total amount of the component (A) and the component (B). The content of the component (A) may be 10 parts by mass or more, 20 parts by mass or more, 30 parts by mass or more, 40 parts by mass or more, 45 parts by mass or more, 50 parts by mass or more, 55 parts by mass or more, or 56 parts by mass or more, from the viewpoint of easily obtaining excellent followability, resolution, and adhesiveness. The content of the component (A) may be 57 parts by mass or more or 58 parts by mass or more, from the viewpoint of easily obtaining excellent developability. The content of the component (A) may be 90 parts by mass or less, 80 parts by mass or less, 75 parts by mass or less, 70 parts by mass or less, 65 parts by mass or less, 60 parts by mass or less, or 59 parts by mass or less, from the viewpoint of easily obtaining excellent followability, resolution, and adhesiveness. The content of the component (A) may be 58 parts by mass or less, 57 parts by mass or less, or 56 parts by mass or less, from the viewpoint of easily obtaining further excellent followability and the viewpoint of easily obtaining excellent sensitivity. From these viewpoints, the content of the component (A) may be 10 to 90 parts by mass or 40 to 70 parts by mass.

In the photosensitive film and the photosensitive resin composition of the present embodiment, the content of a resin having a phenolic hydroxyl group or the content of a novolac resin having a phenolic hydroxyl group may be 30% by mass or less, less than 30% by mass, 20% by mass or less, 15% by mass or less, less than 15% by mass, 10% by mass or less, 5% by mass or less, 1% by mass or less, 0.1% by mass or less, or 0.01% by mass or less, on the basis of the total amount of the photosensitive film or the total amount (the total amount of solid contents) of the photosensitive resin composition. The photosensitive film and the photosensitive resin composition of the present embodiment may not contain a resin having a phenolic hydroxyl group (the above-described content may be substantially 0% by mass), and may not contain a novolac resin having a phenolic hydroxyl group (the above-described content may be substantially 0% by mass).

The photosensitive film and the photosensitive resin composition of the present embodiment contain a photopolymerizable compound (excluding a compound corresponding to the pyrazoline compound) as the component (B). The photopolymerizable compound is a compound that is polymerized by light. The component (B) may be a compound having an ethylenically unsaturated bond, and may be a compound having a (meth)acryloyl group (a (meth)acrylic acid compound).

Examples of the component (B) include a bisphenol A-type (meth)acrylic acid compound, EO-modified di(meth)acrylate, PO-modified di(meth)acrylate, EO/PO-modified di(meth)acrylate, polyalkylene glycol di(meth)acrylate (such as polyethylene glycol di(meth)acrylate and polypropylene glycol di(meth)acrylate), EO-modified polyalkylene glycol di(meth)acrylate, PO-modified polyalkylene glycol di(meth)acrylate, EO/PO-modified polyalkylene glycol di(meth)acrylate, trimethylol propane di(meth)acrylate, trimethylol propane tri(meth)acrylate, EO-modified trimethylol propane tri(meth)acrylate, PO-modified trimethylol propane tri(meth)acrylate, EO/PO-modified trimethylol propane tri(meth)acrylate, tetramethylolmethane tri(meth)acrylate, tetramethylolmethane tetra(meth)acrylate, EO-modified pentaerythritol tetra(meth)acrylate, PO-modified pentaerythritol tetra(meth)acrylate, EO/PO-modified pentaerythritol tetra(meth)acrylate, EO-modified dipentaerythritol hexa(meth)acrylate, PO-modified dipentaerythritol hexa(meth)acrylate, EO/PO-modified dipentaerythritol hexa(meth)acrylate, nonylphenoxypolyethylene oxyacrylate, a phthalic acid-based compound, alkyl (meth)acrylate, and a photopolymerizable compound having at least one cationic polymerizable cyclic ether group in the molecule (such as an oxetane compound). The term "EO-modified" means a compound having a (poly)oxyethylene group. The term "PO-modified" means a compound having a (poly)oxypropylene group. The term "EO/PO-modified" means a compound having a (poly)oxyethylene group and/or a (poly)oxypropylene group.

The component (B) may include a photopolymerizable compound having a (poly)oxyethylene group in which the number of structural units of an oxyethylene group is in the following range (for example, a (meth)acrylic acid compound having a (poly)oxyethylene group), from the viewpoint of easily obtaining excellent followability, resolution, and adhesiveness. The number of structural units of the oxyethylene group may be 1 or more, 2 or more, 3 or more, 4 or more, more than 4, 5 or more, 6 or more, 8 or more, or 10 or more. The number of structural units of the oxyethylene group may be 20 or less, 18 or less, 16 or less, 14 or less, 12 or less, 10 or less, 8 or less, 6 or less, 5 or less, 4 or less, less than 4, or 3 or less. From these viewpoints, the number of structural units of the oxyethylene group may be 1 to 20, 2 to 18, 4 to 16, or 6 to 10. The above-described number of structural units of the oxyethylene group is the total number of structural units of the oxyethylene group in the (poly)oxyethylene group contained in the photopolymerizable compound. For example, in a case where the photopolymerizable compound has two (poly)oxyethylene groups, the above-described number of structural units of the oxyethylene group is the sum of the number of structural units of the oxyethylene group in one of the (poly)oxyethylene groups and the number of structural units of the oxyethylene group in the other of the (poly)oxyethylene groups.

The component (B) may include a bisphenol A-type (meth)acrylic acid compound from the viewpoint of easily obtaining excellent followability, resolution, and adhesiveness. Examples of the bisphenol A-type (meth)acrylic acid compound include 2,2-bis(4-((meth)acryloxypolyethoxy)phenyl)propane (such as 2,2-bis(4-((meth)acryloxypentaethoxy)phenyl)propane), 2,2-bis(4-((meth)acryloxypolypropoxy)phenyl)propane, 2,2-bis(4-((meth)acryloxypolybutoxy)phenyl)propane, and 2,2-bis(4-((meth)acryloxypolyethoxypolypropoxy)phenyl)propane. From the viewpoint of easily obtaining excellent followability, resolution, and adhesiveness, the component (B) may include 2,2-bis(4-((meth)acryloxypolyethoxy)phenyl)propane, and may include 2,2-bis(4-((meth)acryloxypentaethoxy)phenyl)propane.

The molecular weight of the bisphenol A-type (meth)acrylic acid compound may be in the following range from the viewpoint of easily obtaining excellent followability, resolution, and adhesiveness. The molecular weight may be 100 or more, 200 or more, 300 or more, 400 or more, 450 or more, 500 or more, 600 or more, 700 or more, or 800 or more. The molecular weight may be 10000 or less, less than 10000, 8000 or less, 6000 or less, 5000 or less, 3000 or less, 2000 or less, 1500 or less, 1000 or less, 900 or less, 800 or less, 700 or less, 600 or less, or 500 or less. From these viewpoints, the molecular weight may be 100 to 10000.

The content of the bisphenol A-type (meth)acrylic acid compound may be in the following range on the basis of the total mass of the component (B). The content of the bisphenol A-type (meth)acrylic acid compound may be 50% by mass or more, more than 50% by mass, 60% by mass or more, 70% by mass or more, or 75% by mass or more, from the viewpoint of easily obtaining excellent followability, resolution, and adhesiveness. The content of the bisphenol A-type (meth)acrylic acid compound may be 80% by mass or more, 85% by mass or more, or 90% by mass or more, from the viewpoint of easily obtaining further excellent followability and the viewpoint of easily obtaining excellent sensitivity. The content of the bisphenol A-type (meth)acrylic acid compound is 100% by mass or less, and may be less than 100% by mass, 99% by mass or less, 98% by mass or less, 97% by mass or less, 95% by mass or less, 92% by mass or less, or 91% by mass or less, from the viewpoint of easily obtaining excellent followability, resolution, and adhesiveness. The content of the bisphenol A-type (meth)acrylic acid compound may be 90% by mass or less, 85% by mass or less, or 80% by mass or less, from the viewpoint of easily obtaining excellent developability. From these viewpoints, the content of the bisphenol A-type (meth)acrylic acid compound may be 50 to 100% by mass.

The content of the bisphenol A-type (meth)acrylic acid compound may be in the following range with respect to 100 parts by mass of the total amount of the component (A) and the component (B). The content of the bisphenol A-type (meth)acrylic acid compound may be 1 part by mass or more, 5 parts by mass or more, 10 parts by mass or more, 20 parts by mass or more, more than 20 parts by mass, 25 parts by mass or more, more than 25 parts by mass, 30 parts by mass or more, or more than 30 parts by mass, from the viewpoint of easily obtaining excellent followability, resolution, and adhesiveness. The content of the bisphenol A-type (meth)acrylic acid compound may be 32 parts by mass or more, 35 parts by mass or more, more than 35 parts by mass, 38 parts by mass or more, or 40 parts by mass or more, from the viewpoint of easily obtaining further excellent followability and the viewpoint of easily obtaining excellent sensitivity. The content of the bisphenol A-type (meth)acrylic acid compound may be less than 100 parts by mass, 90 parts by mass or less, 80 parts by mass or less, 70 parts by mass or less, 60 parts by mass or less, 50 parts by mass or less, 45 parts by mass or less, or 40 parts by mass or less, from the viewpoint of easily obtaining excellent followability, resolution, and adhesiveness. The content of the bisphenol A-type (meth)acrylic acid compound may be 38 parts by mass or less, 35 parts by mass or less, less than 35 parts by mass, or 32 parts by mass or less, from the viewpoint of easily obtaining excellent developability. From these viewpoints, the content of the bisphenol A-type (meth)acrylic acid compound may be 1 part by mass or more and less than 100 parts by mass.

From the viewpoint of easily obtaining excellent followability, resolution, and adhesiveness, the component (B) may include a (meth)acrylic acid compound having a polyoxyalkylene group (a group in which two or more alkylene groups are linked by an ether bond) (excluding a compound corresponding to the bisphenol A-type (meth)acrylic acid compound), and may include a (meth)acrylic acid compound having at least one selected from the group consisting of a polyoxyethylene group and a polyoxypropylene group (excluding a compound corresponding to the bisphenol A-type (meth)acrylic acid compound).

The molecular weight of the (meth)acrylic acid compound having a polyoxyalkylene group may be in the following range from the viewpoint of easily obtaining excellent followability, resolution, and adhesiveness. The molecular weight may be 100 or more, 200 or more, 300 or more, 400 or more, 500 or more, 600 or more, 700 or more, 800 or more, 900 or more, 1000 or more, or 1100 or more. The molecular weight may be 10000 or less, less than 10000, 8000 or less, 6000 or less, 5000 or less, 3000 or less, 2000 or less, 1500 or less, or 1200 or less. From these viewpoints, the molecular weight may be 100 to 10000.

The content of the (meth)acrylic acid compound having a polyoxyalkylene group may be in the following range on the basis of the total mass of the component (B). The content of the (meth)acrylic acid compound having a polyoxyalkylene group may be more than 0% by mass, and may be 1% by mass or more, 2% by mass or more, 3% by mass or more, 5% by mass or more, 8% by mass or more, or 9% by mass or more, from the viewpoint of easily obtaining excellent followability, resolution, and adhesiveness. The content of the (meth)acrylic acid compound having a polyoxyalkylene group may be 10% by mass or more, 12% by mass or more, 15% by mass or more, 18% by mass or more, 20% by mass or more, or 23% by mass or more, from the viewpoint of easily obtaining excellent developability. The content of the (meth)acrylic acid compound having a polyoxyalkylene group may be 50% by mass or less, less than 50% by mass, 40% by mass or less, 30% by mass or less, or 25% by mass or less, from the viewpoint of easily obtaining excellent followability, resolution, and adhesiveness. The content of the (meth)acrylic acid compound having a polyoxyalkylene group may be 23% by mass or less, 20% by mass or less, 18% by mass or less, 15% by mass or less, 12% by mass or less, or 10% by mass or less, from the viewpoint of easily obtaining further excellent followability and the viewpoint of easily obtaining excellent sensitivity. From these viewpoints, the content of the (meth)acrylic acid compound having a polyoxyalkylene group may be more than 0% by mass and 50% by mass or less.

The content of the (meth)acrylic acid compound having a polyoxyalkylene group may be in the following range with respect to 100 parts by mass of the total amount of the component (A) and the component (B). The content of the (meth)acrylic acid compound having a polyoxyalkylene group may be 0.10 parts by mass or more, 0.50 parts by mass or more, 1.0 part by mass or more, 1.5 parts by mass or more, 2.0 parts by mass or more, 2.5 parts by mass or more, 3.0 parts by mass or more, 3.5 parts by mass or more, or 4.0 parts by mass or more, from the viewpoint of easily obtaining excellent followability, resolution, and adhesiveness. The content of the (meth)acrylic acid compound having a polyoxyalkylene group may be 4.5 parts by mass or more, 5.0 parts by mass or more, 6.0 parts by mass or more, 7.0 parts by mass or more, 8.0 parts by mass or more, 8.5 parts by mass or more, 9.0 parts by mass or more, or 9.5 parts by mass or more, from the viewpoint of easily obtaining excellent developability. The content of the (meth)acrylic acid compound having a polyoxyalkylene group may be 50 parts by mass or less, 30 parts by mass or less, 25 parts by mass or less, 20 parts by mass or less, 18 parts by mass or less, 15 parts by mass or less, 12 parts by mass or less, 10 parts by mass or less, or 9.5 parts by mass or less, from the viewpoint of easily obtaining excellent followability, resolution, and adhesiveness. The content of the (meth)acrylic acid compound having a polyoxyalkylene group may be 9.0 parts by mass or less, 8.5 parts by mass or less, 8.0 parts by mass or less, 7.0 parts by mass or less, 6.0 parts by mass or less, 5.0 parts by mass or less, or 4.0 parts by mass or less, from the viewpoint of easily obtaining further excellent followability and the viewpoint of easily obtaining excellent sensitivity. From these viewpoints, the content of the (meth)acrylic acid compound having a polyoxyalkylene group may be 0.10 to 50 parts by mass.

In a case where the component (B) includes a bisphenol A-type (meth)acrylic acid compound and a (meth)acrylic acid compound having a polyoxyalkylene group, the content of the (meth)acrylic acid compound having a polyoxyalkylene group may be in the following range with respect to 100 parts by mass of the bisphenol A-type (meth)acrylic acid compound. The content of the (meth)acrylic acid compound having a polyoxyalkylene group may be 1 part by mass or more, 2 parts by mass or more, 3 parts by mass or more, 5 parts by mass or more, 8 parts by mass or more, or 10 parts by mass or more, from the viewpoint of easily obtaining excellent followability, resolution, and adhesiveness. The content of the (meth)acrylic acid compound having a polyoxyalkylene group may be 15 parts by mass or more, 20 parts by mass or more, 25 parts by mass or more, or 30 parts by mass or more, from the viewpoint of easily obtaining excellent developability. The content of the (meth)acrylic acid compound having a polyoxyalkylene group may be 100 parts by mass or less, less than 100 parts by mass, 80 parts by mass or less, 50 parts by mass or less, 45 parts by mass or less, 40 parts by mass or less, 35 parts by mass or less, or 30 parts by mass or less, from the viewpoint of easily obtaining excellent followability, resolution, and adhesiveness. The content of the (meth)acrylic acid compound having a polyoxyalkylene group may be 25 parts by mass or less, 20 parts by mass or less, 15 parts by mass or less, or 10 parts by mass or less, from the viewpoint of easily obtaining further excellent followability and the viewpoint of easily obtaining excellent sensitivity. From these viewpoints, the content of the (meth)acrylic acid compound having a polyoxyalkylene group may be 1 to 100 parts by mass.

The content of the component (B) may be in the following range on the basis of the total amount of the photosensitive film or the total amount (the total amount of solid contents) of the photosensitive resin composition. The content of the component (B) may be 10% by mass or more, 15% by mass or more, 20% by mass or more, 25% by mass or more, 30% by mass or more, 35% by mass or more, or 38% by mass or more, from the viewpoint of easily obtaining excellent followability, resolution, and adhesiveness. The content of the component (B) may be 40% by mass or more or 41% by mass or more, from the viewpoint of easily obtaining further excellent followability and the viewpoint of easily obtaining excellent sensitivity. The content of the component (B) may be 90% by mass or less, 80% by mass or less, 70% by mass or less, 65% by mass or less, 60% by mass or less, 55% by mass or less, 50% by mass or less, 45% by mass or less, or 42% by mass or less, from the viewpoint of easily obtaining excellent followability, resolution, and adhesiveness. The content of the component (B) may be 41% by mass or less or 40% by mass or less, from the viewpoint of easily obtaining excellent developability. From these viewpoints, the content of the component (B) may be 10 to 90% by mass.

The content of the component (B) may be in the following range with respect to 100 parts by mass of the total amount of the component (A) and the component (B). The content of the component (B) may be 10 parts by mass or more, 20 parts by mass or more, 25 parts by mass or more, 30 parts by mass or more, 35 parts by mass or more, 40 parts by mass or more, or 41 parts by mass or more, from the viewpoint of easily obtaining excellent followability, resolution, and adhesiveness. The content of the component (B) may be 42 parts by mass or more, 43 parts by mass or more, or 44 parts by mass or more, from the viewpoint of easily obtaining further excellent followability and the viewpoint of easily obtaining excellent sensitivity. The content of the component (B) may be 90 parts by mass or less, 80 parts by mass or less, 70 parts by mass or less, 60 parts by mass or less, 55 parts by mass or less, 50 parts by mass or less, 45 parts by mass or less, or 44 parts by mass or less, from the viewpoint of easily obtaining excellent followability, resolution, and adhesiveness. The content of the component (B) may be 43 parts by mass or less or 42 parts by mass or less, from the viewpoint of easily obtaining excellent developability. From these viewpoints, the content of the component (B) may be 10 to 90 parts by mass or 30 to 60 parts by mass.

In the photosensitive film and the photosensitive resin composition of the present embodiment, the total amount of a compound having three or more ethylenically unsaturated groups and a di(meth)acrylate compound having a bisphenol A skeleton may be 20 parts by mass or less, less than 20 parts by mass, 10 parts by mass or less, 1 part by mass or less, or 0.1 parts by mass or less, with respect to 100 parts by mass of the total amount of the component (A) and the component (B). The photosensitive film and the photosensitive resin composition of the present embodiment may not contain at least one selected from the group consisting of a compound having three or more ethylenically unsaturated groups and a di(meth)acrylate compound having a bisphenol A skeleton (the content thereof may be substantially 0 parts by mass with respect to 100 parts by mass of the total amount of the component (A) and the component (B)).

In the photosensitive film and the photosensitive resin composition of the present embodiment, the content of a photopolymerizable compound having an ethylenically unsaturated group and an isocyanuric ring structure may be 1 part by mass or less, less than 1 part by mass, 0.1 parts by mass or less, 0.01 parts by mass or less, or 0.001 parts by mass or less, with respect to 100 parts by mass of the total amount of the component (A) and the component (B). The photosensitive film and the photosensitive resin composition of the present embodiment may not contain a photopolymerizable compound having an ethylenically unsaturated group and an isocyanuric ring structure (the above-described content may be substantially 0 parts by mass).

In the photosensitive film and the photosensitive resin composition of the present embodiment, the content of at least one selected from the group consisting of a photopolymerizable compound having a skeleton derived from pentaerythritol and a photopolymerizable compound having a skeleton derived from dipentaerythritol may be 3 parts by mass or less, less than 3 parts by mass, 1 part by mass or less, 0.1 parts by mass or less, or 0.01 parts by mass or less, with respect to 100 parts by mass of the total amount of the component (A) and the component (B). The photosensitive film and the photosensitive resin composition of the present embodiment may not contain at least one selected from the group consisting of a photopolymerizable compound having a skeleton derived from pentaerythritol and a photopolymerizable compound having a skeleton derived from dipentaerythritol (the content thereof may be substantially 0 parts by mass with respect to 100 parts by mass of the total amount of the component (A) and the component (B)). In the photosensitive film and the photosensitive resin composition of the present embodiment, the content of at least one selected from the group consisting of a (meth)acrylic acid compound having a skeleton derived from pentaerythritol and a (meth)acrylic acid compound having a skeleton derived from dipentaerythritol may be 3 parts by mass or less, less than 3 parts by mass, 1 part by mass or less, 0.1 parts by mass or less, or 0.01 parts by mass or less, with respect to 100 parts by mass of the total amount of the component (A) and the component (B). The photosensitive film and the photosensitive resin composition of the present embodiment may not contain at least one selected from the group consisting of a (meth)acrylic acid compound having a skeleton derived from pentaerythritol and a (meth)acrylic acid compound having a skeleton derived from dipentaerythritol (the content thereof may be substantially 0 parts by mass with respect to 100 parts by mass of the total amount of the component (A) and the component (B)).

In the photosensitive film and the photosensitive resin composition of the present embodiment, the content of a bisphenol F-type (meth)acrylic acid compound (a (meth)acrylic acid compound having a bisphenol F structure) or the content of a bisphenol F-type acrylic acid compound may be 5% by mass or less, less than 5% by mass, 1% by mass or less, less than 1% by mass, 0.1% by mass or less, 0.01% by mass or less, or 0.001% by mass or less, on the basis of the total mass of the component (B). In the photosensitive film and the photosensitive resin composition of the present embodiment, the content of the bisphenol F-type (meth)acrylic acid compound or the content of the bisphenol F-type acrylic acid compound may be 0.2% by mass or less, 0.15% by mass or less, less than 0.15% by mass, 0.1% by mass or less, or 0.01% by mass or less, on the basis of the total amount of the photosensitive film or the total amount (the total amount of solid contents) of the photosensitive resin composition. The photosensitive film and the photosensitive resin composition of the present embodiment may not contain a bisphenol F-type (meth)acrylic acid compound (the above-described each content may be substantially 0% by mass), and may not contain a bisphenol F-type acrylic acid compound (the above-described each content may be substantially 0% by mass).

In the photosensitive film and the photosensitive resin composition of the present embodiment, the content of an epoxy compound having two or more oxirane rings or the content of an aliphatic or alicyclic epoxy compound having two or more oxirane rings may be 40 parts by mass or less, less than 40 parts by mass, 20 parts by mass or less, less than 20 parts by mass, 10 parts by mass or less, less than 10 parts by mass, 1 part by mass or less, 0.1 parts by mass or less, or 0.01 parts by mass or less, with respect to 100 parts by mass of the component (A). The photosensitive film and the photosensitive resin composition of the present embodiment may not contain an epoxy compound having two or more oxirane rings (the above-described content may be substantially 0 parts by mass), and may not contain an aliphatic or alicyclic epoxy compound having two or more oxirane rings (the above-described content may be substantially 0 parts by mass).

The photosensitive film and the photosensitive resin composition of the present embodiment contain a photopolymerization initiator (excluding a compound corresponding to the pyrazoline compound) as the component (C).

Examples of the component (C) include a hexaarylbiimidazole compound; aromatic ketones such as benzophenone, 2-benzyl-2-dimethylamino-1-(4-morpholinophenyl)-1-butanone, 2-(dimethylamino)-2-[(4-methylphenyl)methyl]-1-[4-(4-morpholinyl)phenyl] -1 -butanone, 4-(2-hydroxyethoxy)phenyl-2-(hydroxy-2-propyl)ketone, and 2-methyl-1-[4-(methylthio)phenyl]-2-morpholino-propanone-1; quinone compounds such as alkylanthraquinone; benzoinether compounds such as benzoinalkyl ethers; benzoin compounds such as benzoin and alkylbenzoin; benzyl derivatives such as benzyldimethylketal; bis(2,4,6-trimethylbenzoyl)-phenylphosphine oxide; bis(2,6-dimethylbenzoyl)-2,4,4-trimethyl-pentylphosphine oxide; and (2,4,6-trimethylbenzoyl)ethoxyphenylphosphine oxide.

The component (C) may include a hexaarylbiimidazole compound from the viewpoint of easily obtaining excellent followability, resolution, and adhesiveness. The aryl group in the hexaarylbiimidazole compound may be a phenyl group or the like. A hydrogen atom bonded to the aryl group in the hexaarylbiimidazole compound may be substituted with a halogen atom (a chlorine atom or the like).

The hexaarylbiimidazole compound may be a 2,4,5-triarylimidazole dimer. Examples of the 2,4,5-triarylimidazole dimer include a 2-(o-chlorophenyl)-4,5-diphenylimidazole dimer, a 2-(o-chlorophenyl)-4,5-bis-(m-methoxyphenyl)imidazole dimer, and a 2-(p-methoxyphenyl)-4,5-diphenylimidazole dimer. The hexaarylbiimidazole compound may include a 2-(o-chlorophenyl)-4,5-diphenylimidazole dimer, and may include 2,2'-bis(o-chlorophenyl)-4,4',5,5'-tetraphenyl-1,2'-biimidazole, from the viewpoint of easily obtaining excellent followability, resolution, and adhesiveness.

The content of the hexaarylbiimidazole compound may be 50% by mass or more, more than 50% by mass, 70% by mass or more, 90% by mass or more, 95% by mass or more, 98% by mass or more, 99% by mass or more, or substantially 100% by mass (an embodiment in which the component (C) is substantially composed of the hexaarylbiimidazole compound), on the basis of the total amount of the component (C), from the viewpoint of easily obtaining excellent followability, resolution, and adhesiveness.

The content of the component (C) may be in the following range on the basis of the total amount of the photosensitive film or the total amount (the total amount of solid contents) of the photosensitive resin composition, from the viewpoint of easily obtaining excellent followability, resolution, and adhesiveness. The content of the component (C) may be 0.10% by mass or more, 0.50% by mass or more, 1.0% by mass or more, 2.0% by mass or more, 3.0% by mass or more, 4.0% by mass or more, 4.5% by mass or more, or 4.7% by mass or more. The content of the component (C) may be 20% by mass or less, 15% by mass or less, 12% by mass or less, 10% by mass or less, 8.0% by mass or less, 7.0% by mass or less, 6.0% by mass or less, or 5.0% by mass or less. From these viewpoints, the content of the component (C) may be 0.10 to 20% by mass.

The content of the component (C) may be in the following range with respect to 100 parts by mass of the total amount of the component (A) and the component (B), from the viewpoint of easily obtaining excellent followability, resolution, and adhesiveness. The content of the component (C) may be 0.10 parts by mass or more, 0.50 parts by mass or more, 1.0 part by mass or more, 2.0 parts by mass or more, 3.0 parts by mass or more, 3.5 parts by mass or more, 4.0 parts by mass or more, 4.5 parts by mass or more, or 5.0 parts by mass or more. The content of the component (C) may be 20 parts by mass or less, 15 parts by mass or less, 12 parts by mass or less, 10 parts by mass or less, 8.0 parts by mass or less, 7.0 parts by mass or less, 6.0 parts by mass or less, or 5.5 parts by mass or less. From these viewpoints, the content of the component (C) may be 0.10 to 20 parts by mass.

The photosensitive film and the photosensitive resin composition of the present embodiment contain a pyrazoline compound (a compound having a pyrazoline ring) as the component (D). The component (D) can be used as a sensitizer (photosensitizer). The molecular weight of the component (D) may be less than 10000.

Examples of the pyrazoline compound include a 1-pyrazoline compound, a 2-pyrazoline compound, and a 3-pyrazoline compound. The pyrazoline compound may include 2-pyrazoline compound from the viewpoint of easily obtaining excellent followability, resolution, and adhesiveness.

The pyrazoline compound may have a substituent bonded to a pyrazoline ring, and may include a compound having a substituent bonded to at least one selected from the group consisting of the 1-position, the 3-position, and the 5-position of a pyrazoline ring. Examples of the substituent include an alkyl group (such as an alkyl group having 1 to 20 carbon atoms (an acyclic alkyl group) and a cycloalkyl group having 5 to 12 carbon atoms), an aryl group (such as a phenyl group, an aralkyl group (such as a benzyl group and a phenethyl group), a benzoyl group, and a styryl group), a vinyl group, a hydroxy group, a carboxy group, a carboxylate group, an aldehyde group, an alkoxy group (an unsubstituted alkoxy group and substituted alkoxy group (such as a hydroxyalkoxy group)), a carbonyl group, an alkoxycarbonyl group, an alkanoyl group (such as an alkanoyl group having 2 to 12 carbon atoms), an oxycarbonyl group, a carbonyloxy group, an amino group, an epoxy group, a furyl group, a cyano group, a halogeno group (such as a fluoro group, a chloro group, and a bromo group), a nitro group, an acetyl group, a sulfonyl group, and a sulfonamide group. The benzene ring of the aryl group may have a substituent, and examples of the substituent include an alkyl group, an alkoxy group (such as a methoxy group, an ethoxy group, and a propoxy group), a halogeno group (such as a fluoro group, a chloro group, and a bromo group), and a sulfonamide group. The substituent may be an alkyl ester group (for example, an alkyl ester group having 1 to 6 carbon atoms), an alkylamino group (for example, an alkylamino group having 1 to 20 carbon atoms), or the like.

From the viewpoint of easily obtaining excellent followability, resolution, and adhesiveness, the component (D) may include at least one selected from the group consisting of a compound represented by General Formula (d1) below and a compound represented by General Formula (d2) below, and may include a compound represented by General Formula (d1) below. 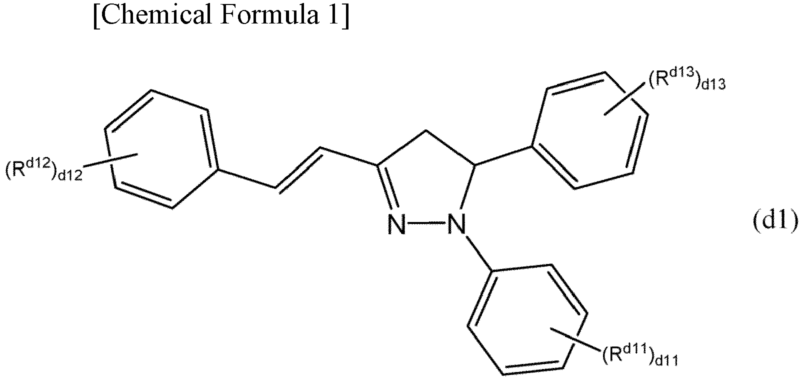 [in Formula (d1), R^{d11}, R^{d12}, and R^{d13} each independently represent an alkoxy group (for example, an alkoxy group having 1 to 10 carbon atoms) or an alkyl group (for example, an alkyl group having 1 to 3 carbon atoms), and d11, d12, and d13 each independently represent an integer of 0 to 5. A plurality of R^{d11} may be the same as or different from one another in a case where d11 is 2 or more, a plurality of R^{d12} may be the same as or different from one another in a case where d12 is 2 or more, and a plurality of R^{d13} may be the same as or different from one another in a case where d13 is 2 or more.]

In Formula (d1), at least one of R^{d11}, R^{d12}, and R^{d13} may be an alkoxy group (for example, an alkoxy group having 1 to 10 carbon atoms) or an alkyl group (for example, an alkyl group having 1 to 3 carbon atoms). From the viewpoint of easily obtaining excellent followability, resolution, and adhesiveness, at least one selected from the group consisting of R^{d12} and R^{d13} may be an alkoxy group, and may be a methoxy group, an ethoxy group, or a propoxy group. d11 may be 0 from the viewpoint of easily obtaining excellent followability, resolution, and adhesiveness. From the viewpoint of easily obtaining excellent followability, resolution, and adhesiveness, at least one selected from the group consisting of d12 and d13 may be 0, 1, 2, or 3, and may be 1. The sum of d11, d12, and d13 may be 0 to 6 or 1 to 6. 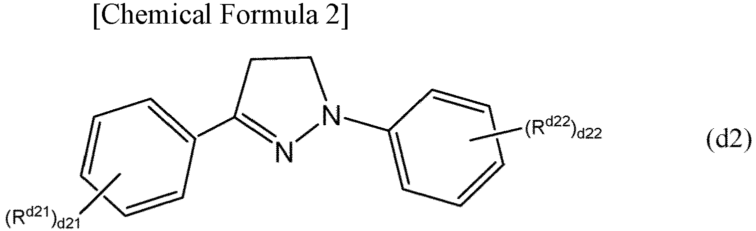 [in Formula (d2), R^{d21} and R^{d22} each independently represent an alkyl group (such as an alkyl group having 1 to 20 carbon atoms (an acyclic alkyl group) or a cycloalkyl group having 5 to 12 carbon atoms), an alkoxy group (for example, an alkoxy group having 1 to 6 carbon atoms), an amino group, a halogeno group, a carboxy group, a cyano group, a nitro group, an acetyl group, a sulfonyl group, or a sulfonamide group, and d21 and d22 each independently represent an integer of 0 to 5. A plurality of R^{d21} may be the same as or different from one another in a case where d21 is 2 or more, and a plurality of R^{d22} may be the same as or different from one another in a case where d22 is 2 or more.]

In Formula (d2), R^{d21} may be a halogeno group, and may be a fluoro group, a chloro group, or a bromo group. R^{d22} may be a sulfonamide group. At least one selected from the group consisting of d21 and d22 may be 0, 1, 2, or 3, and may be 1.

Examples of the pyrazoline compound include 1-phenyl-3-(4-isopropyl styryl)-5-(4-isopropyl phenyl)-pyrazoline, 1-phenyl-3-(4-tert-butyl styryl)-5-(4-tert-butyl phenyl)-pyrazoline, 1-phenyl-3-(4-methoxystyryl)-5-(4-methoxyphenyl)-pyrazoline, 1-phenyl-3-(3,5-dimethoxystyryl)-5-(3,5-dimethoxyphenyl)-pyrazoline, 1-phenyl-3-(3,4-dimethoxystyryl)-5-(3,4-dimethoxyphenyl)-pyrazoline, 1-phenyl-3-(2,6-dimethoxystyryl)-5-(2,6-dimethoxyphenyl)-pyrazoline, 1-phenyl-3-(2,5-dimethoxystyryl)-5-(2,5-dimethoxyphenyl)-pyrazoline, 1-phenyl-3-(2,3-dimethoxystyryl)-5-(2,3-dimethoxyphenyl)-pyrazoline, 1-phenyl-3-(2,4-dimethoxystyryl)-5-(2,4-dimethoxyphenyl)-pyrazoline, 1-(4-(benzoxazole-2-yl)phenyl)-3-(4-tert-butyl styryl)-5-(4-tert-butyl phenyl)-pyrazoline, and 4-[[3-(4-chlorophenyl)-4,5-dihydro-1H-pyrazole] -1 -yl]benzenesulphonamide.

From the viewpoint of easily obtaining excellent followability, resolution, and adhesiveness, the pyrazoline compound may include a compound having an aryl group bonded to a pyrazoline ring (such as a compound having two or more (for example, two or three) aryl groups bonded to a pyrazoline ring), may include a compound having an aryl group bonded to at least one selected from the group consisting of the 1-position, the 3-position, and the 5-position of a pyrazoline ring, may include a compound having a phenyl group (a phenyl group which may have a substituent) bonded to at least one selected from the group consisting of the 1-position, the 3-position, and the 5-position of a pyrazoline ring, and may include at least one selected from the group consisting of 1-phenyl-3-(4-methoxystyryl)-5-(4-methoxyphenyl)pyrazoline and 4-[[3-(4-chlorophenyl)-4,5-dihydro-1H-pyrazole]-1-yl]benzenesulphonamide. From the viewpoint of easily obtaining excellent followability, resolution, and adhesiveness, the pyrazoline compound may include a compound having at least one selected from the group consisting of an alkoxyphenyl group and an alkoxystyryl group, and may include a compound having at least one selected from the group consisting of an alkoxyphenyl group and an alkoxystyryl group as a functional group bonded to a pyrazoline ring. That is, the pyrazoline compound may include a compound having an alkoxyphenyl group bonded to a pyrazoline ring, and may include a compound having an alkoxystyryl group bonded to a pyrazoline ring.

The content of the component (D) may be in the following range on the basis of the total amount of the photosensitive film or the total amount (the total amount of solid contents) of the photosensitive resin composition. The content of the component (D) may be 0.01% by mass or more, 0.03% by mass or more, 0.05% by mass or more, 0.08% by mass or more, 0.10% by mass or more, more than 0.10% by mass, 0.12% by mass or more, 0.15% by mass or more, 0.18% by mass or more, or 0.19% by mass or more, from the viewpoint of easily obtaining excellent followability, resolution, and adhesiveness. The content of the component (D) may be 0.20% by mass or more, 0.23% by mass or more, 0.25% by mass or more, or 0.28% by mass or more, from the viewpoint of easily obtaining further excellent adhesiveness and the viewpoint of easily obtaining excellent sensitivity. The content of the component (D) may be 5.0% by mass or less, 3.0% by mass or less, 1.0% by mass or less, 0.80% by mass or less, 0.70% by mass or less, 0.60% by mass or less, 0.50% by mass or less, 0.40% by mass or less, 0.35% by mass or less, 0.30% by mass or less, or 0.28% by mass or less, from the viewpoint of easily obtaining excellent followability, resolution, and adhesiveness. The content of the component (D) may be 0.25% by mass or less, 0.23% by mass or less, 0.20% by mass or less, or 0.19% by mass or less, from the viewpoint of easily obtaining further excellent followability. From these viewpoints, the content of the component (D) may be 0.01 to 5.0% by mass or 0.10 to 1.0% by mass.

The content of the component (D) may be in the following range with respect to 100 parts by mass of the total amount of the component (A) and the component (B). The content of the component (D) may be 0.01 parts by mass or more, 0.02 parts by mass or more, more than 0.02 parts by mass, 0.03 parts by mass or more, 0.05 parts by mass or more, 0.08 parts by mass or more, 0.10 parts by mass or more, more than 0.10 parts by mass, 0.12 parts by mass or more, 0.15 parts by mass or more, 0.18 parts by mass or more, or 0.20 parts by mass or more, from the viewpoint of easily obtaining excellent followability, resolution, and adhesiveness. The content of the component (D) may be 0.21 parts by mass or more, 0.23 parts by mass or more, 0.25 parts by mass or more, 0.28 parts by mass or more, or 0.30 parts by mass or more, from the viewpoint of easily obtaining further excellent adhesiveness and the viewpoint of easily obtaining excellent sensitivity. The content of the component (D) may be 5.0 parts by mass or less, 3.0 parts by mass or less, 1.0 part by mass or less, 0.80 parts by mass or less, 0.70 parts by mass or less, 0.60 parts by mass or less, 0.50 parts by mass or less, 0.40 parts by mass or less, 0.35 parts by mass or less, or 0.30 parts by mass or less, from the viewpoint of easily obtaining excellent followability, resolution, and adhesiveness. The content of the component (D) may be 0.28 parts by mass or less, 0.25 parts by mass or less, 0.23 parts by mass or less, 0.21 parts by mass or less, or 0.20 parts by mass or less, from the viewpoint of easily obtaining further excellent followability. From these viewpoints, the content of the component (D) may be 0.01 to 5.0 parts by mass, 0.03 to 5.0 parts by mass, or 0.10 to 1.0 part by mass.

The content of the component (D) may be in the following range with respect to 100 parts by mass of the component (A). The content of the component (D) may be 0.01 parts by mass or more, 0.03 parts by mass or more, 0.05 parts by mass or more, 0.08 parts by mass or more, 0.10 parts by mass or more, 0.15 parts by mass or more, 0.20 parts by mass or more, 0.25 parts by mass or more, 0.30 parts by mass or more, 0.35 parts by mass or more, or 0.36 parts by mass or more, from the viewpoint of easily obtaining excellent followability, resolution, and adhesiveness. The content of the component (D) may be 0.40 parts by mass or more, 0.45 parts by mass or more, 0.50 parts by mass or more, or 0.54 parts by mass or more, from the viewpoint of easily obtaining further excellent adhesiveness and the viewpoint of easily obtaining excellent sensitivity. The content of the component (D) may be 5.0 parts by mass or less, 3.0 parts by mass or less, 1.0 part by mass or less, 0.80 parts by mass or less, 0.70 parts by mass or less, 0.60 parts by mass or less, 0.55 parts by mass or less, or 0.54 parts by mass or less, from the viewpoint of easily obtaining excellent followability, resolution, and adhesiveness. The content of the component (D) may be 0.54 parts by mass or less, 0.50 parts by mass or less, 0.45 parts by mass or less, 0.40 parts by mass or less, or 0.36 parts by mass or less, from the viewpoint of easily obtaining further excellent followability. From these viewpoints, the content of the component (D) may be 0.01 to 5.0 parts by mass, 0.04 to 5.0 parts by mass, or 0.10 to 1.0 part by mass.

The content of the component (D) may be in the following range with respect to 100 parts by mass of the component (B). The content of the component (D) may be 0.01 parts by mass or more, 0.03 parts by mass or more, 0.05 parts by mass or more, 0.08 parts by mass or more, 0.10 parts by mass or more, 0.15 parts by mass or more, 0.20 parts by mass or more, 0.25 parts by mass or more, 0.30 parts by mass or more, 0.35 parts by mass or more, 0.40 parts by mass or more, or 0.45 parts by mass or more, from the viewpoint of easily obtaining excellent followability, resolution, and adhesiveness. The content of the component (D) may be 0.50 parts by mass or more, 0.51 parts by mass or more, 0.55 parts by mass or more, 0.60 parts by mass or more, 0.65 parts by mass or more, or 0.68 parts by mass or more, from the viewpoint of easily obtaining further excellent adhesiveness and the viewpoint of easily obtaining excellent sensitivity. The content of the component (D) may be 5.0 parts by mass or less, 3.0 parts by mass or less, 1.0 part by mass or less, 0.80 parts by mass or less, 0.70 parts by mass or less, or 0.68 parts by mass or less, from the viewpoint of easily obtaining excellent followability, resolution, and adhesiveness. The content of the component (D) may be 0.65 parts by mass or less, 0.60 parts by mass or less, 0.55 parts by mass or less, 0.51 parts by mass or less, 0.50 parts by mass or less, or 0.45 parts by mass or less, from the viewpoint of easily obtaining further excellent followability. From these viewpoints, the content of the component (D) may be 0.01 to 5.0 parts by mass, 0.05 to 5.0 parts by mass, or 0.10 to 1.0 part by mass.

The content of the component (D) may be in the following range with respect to 100 parts by mass of the total amount of the component (C) and the component (D). The content of the component (D) may be 0.10 parts by mass or more, 0.50 parts by mass or more, 0.80 parts by mass or more, 1.0 part by mass or more, 1.5 parts by mass or more, 2.0 parts by mass or more, 2.5 parts by mass or more, 3.0 parts by mass or more, 3.5 parts by mass or more, or 3.8 parts by mass or more, from the viewpoint of easily obtaining excellent followability, resolution, and adhesiveness. The content of the component (D) may be 4.0 parts by mass or more, 4.5 parts by mass or more, 5.0 parts by mass or more, more than 5.0 parts by mass, 5.5 parts by mass or more, or 5.7 parts by mass or more, from the viewpoint of easily obtaining further excellent adhesiveness and the viewpoint of easily obtaining excellent sensitivity. The content of the component (D) may be 20 parts by mass or less, 15 parts by mass or less, 10 parts by mass or less, 9.0 parts by mass or less, 8.0 parts by mass or less, 7.0 parts by mass or less, 6.0 parts by mass or less, or 5.7 parts by mass or less, from the viewpoint of easily obtaining excellent followability, resolution, and adhesiveness. The content of the component (D) may be 5.5 parts by mass or less, 5.0 parts by mass or less, less than 5.0 parts by mass, 4.5 parts by mass or less, 4.0 parts by mass or less, or 3.8 parts by mass or less, from the viewpoint of easily obtaining further excellent followability. From these viewpoints, the content of the component (D) may be 0.10 to 20 parts by mass or 1.0 to 10 parts by mass.

The photosensitive film and the photosensitive resin composition of the present embodiment may contain a polymerization inhibitor (excluding a compound corresponding to any one of the components (A) to (D)), and may not contain a polymerization inhibitor. The polymerization inhibitor suppresses polymerization at an unexposed area at the time of forming a resist pattern, and temporal stability of sensitivity, resolution, and adhesiveness are easily improved. Examples of the polymerization inhibitor include a catechol compound (for example, tert-butylcatechol such as 4-tert-butylcatechol), hindered amine (for example, 2,2,6,6-tetramethyl-4-hydroxypiperidine-1-oxyl), and 4-hydroxy-2,2,6,6-tetramethylpiperidine-N-oxyl. The photosensitive film and the photosensitive resin composition of the present embodiment may contain a catechol compound from the viewpoint of easily obtaining excellent temporal stability of sensitivity and the viewpoint of easily obtaining excellent resolution and adhesiveness.

As a content X, the content of the polymerization inhibitor or the content of the catechol compound may be in the following range on the basis of the total amount of the photosensitive film or the total amount (the total amount of solid contents) of the photosensitive resin composition. The content X may be 0.001% by mass or more, 0.003% by mass or more, 0.005% by mass or more, 0.008% by mass or more, or 0.009% by mass or more, from the viewpoint of easily obtaining excellent temporal stability of sensitivity and the viewpoint of easily obtaining excellent followability, resolution, and adhesiveness. The content X may be 0.010% by mass or more, more than 0.010% by mass, 0.011% by mass or more, 0.012% by mass or more, or 0.014% by mass or more, from the viewpoint of easily obtaining further excellent resolution. The content X may be 0.100% by mass or less, 0.080% by mass or less, 0.050% by mass or less, 0.040% by mass or less, 0.030% by mass or less, 0.020% by mass or less, or 0.015% by mass or less, from the viewpoint of easily obtaining excellent temporal stability of sensitivity and the viewpoint of easily obtaining excellent followability, resolution, and adhesiveness. The content X may be 0.014% by mass or less, 0.012% by mass or less, 0.011% by mass or less, or 0.010% by mass or less, from the viewpoint of easily obtaining further excellent followability and the viewpoint of easily obtaining excellent sensitivity. From these viewpoints, the content X may be 0.001 to 0.100% by mass.

The content X may be 0% by mass and may be more than 0% by mass.

As a content Y, the content of the polymerization inhibitor or the content of the catechol compound may be in the following range with respect to 100 parts by mass of the total amount of the component (A) and the component (B). The content Y may be 0.001 parts by mass or more, 0.003 parts by mass or more, 0.005 parts by mass or more, 0.008 parts by mass or more, 0.009 parts by mass or more, or 0.010 parts by mass or more, from the viewpoint of easily obtaining excellent temporal stability of sensitivity and the viewpoint of easily obtaining excellent followability, resolution, and adhesiveness. The content Y may be more than 0.010 parts by mass, 0.011 parts by mass or more, 0.012 parts by mass or more, 0.014 parts by mass or more, or 0.015 parts by mass or more, from the viewpoint of easily obtaining further excellent resolution. The content Y may be 0.100 parts by mass or less, 0.080 parts by mass or less, 0.050 parts by mass or less, 0.040 parts by mass or less, 0.030 parts by mass or less, 0.020 parts by mass or less, or 0.015 parts by mass or less, from the viewpoint of easily obtaining excellent temporal stability of sensitivity and the viewpoint of easily obtaining excellent followability, resolution, and adhesiveness. The content Y may be 0.014 parts by mass or less, 0.012 parts by mass or less, 0.011 parts by mass or less, or 0.010 parts by mass or less, from the viewpoint of easily obtaining further excellent followability and the viewpoint of easily obtaining excellent sensitivity. From these viewpoints, the content Y may be 0.001 to 0.100 parts by mass.

The content Y may be 0 parts by mass and may be more than 0 parts by mass.

The photosensitive resin composition of the present embodiment may contain an organic solvent. Examples of the organic solvent include methanol, ethanol, acetone, methyl ethyl ketone, methyl cellosolve, ethyl cellosolve, toluene, N,N-dimethylformamide, and propylene glycol monomethyl ether.

The photosensitive film and the photosensitive resin composition of the present embodiment may contain other component which is other than the above-described components (excluding a compound corresponding to any one of the components (A) to (D)). Examples of the other components include hydrogen donors (such as bis[4-(dimethylamino)phenyl]methane, bis[4-(diethylamino)phenyl]methane, leuco crystal violet, and N-phenylglycine), dyes (such as malachite green), sensitizers, tribromophenylsulfone, photochromic agents, thermal development inhibitors, plasticizers (such as p-toluenesulfonamide), pigments, fillers, antifoaming agents, flame retardants, stabilizers, tackifiers, leveling agents, release promoters, antioxidants, aromatics, imaging agents, and thermal crosslinking agents.

In the photosensitive film and the photosensitive resin composition of the present embodiment, the content of a thermal radical polymerization initiator may be 0.5% by mass or less, less than 0.5% by mass, 0.1% by mass or less, 0.01% by mass or less, or 0.001 % by mass or less, on the basis of the total amount of the photosensitive film or the total amount (the total amount of solid contents) of the photosensitive resin composition. The photosensitive film and the photosensitive resin composition of the present embodiment may not contain a thermal radical polymerization initiator (the above-described content may be substantially 0% by mass).

In the photosensitive film and the photosensitive resin composition of the present embodiment, the content of at least one selected from the group consisting of a vinyl polymer (for example, a vinyl polymer including a side chain having an epoxy group) and an oxetane compound (for example, an oxetane compound having two or more oxetane rings which may have a substituent) may be 20% by mass or less, less than 20% by mass, 10% by mass or less, 1% by mass or less, 0.1% by mass or less, 0.01% by mass or less, or 0.001% by mass or less, on the basis of the total amount of the photosensitive film or the total amount (the total amount of solid contents) of the photosensitive resin composition. The photosensitive film and the photosensitive resin composition of the present embodiment may not contain at least one selected from the group consisting of a vinyl polymer (for example, a vinyl polymer including a side chain having an epoxy group) and an oxetane compound (for example, an oxetane compound having two or more oxetane rings which may have a substituent) (the above-described content may be substantially 0% by mass).

In the photosensitive film and the photosensitive resin composition of the present embodiment, the content of at least one selected from the group consisting of an anthracene compound (a compound having an anthracene ring; for example, 9,10-dibutoxyanthracene), a distyrylbenzene compound (a compound having a benzene ring to which two styryl groups are bonded), and a naphthalene compound (a compound having a naphthalene ring) may be 0.01% by mass or less, less than 0.01% by mass, 0.001% by mass or less, or 0.0001% by mass or less, on the basis of the total amount of the photosensitive film or the total amount (the total amount of solid contents) of the photosensitive resin composition. The photosensitive film and the photosensitive resin composition of the present embodiment may not contain at least one selected from the group consisting of an anthracene compound, a distyrylbenzene compound, and a naphthalene compound (the above-described content may be substantially 0% by mass).

In the photosensitive film and the photosensitive resin composition of the present embodiment, the content of a nitroxyl compound (a compound having a nitroxyl group) may be 0.005 parts by mass or less, less than 0.005 parts by mass, 0.001 parts by mass or less, or 0.0001 parts by mass or less, with respect to 100 parts by mass of the component (A) or 100 parts by mass of the total amount of the component (A) and the component (B). The photosensitive film and the photosensitive resin composition of the present embodiment may not contain a nitroxyl compound (the above-described content may be substantially 0 parts by mass).

In the photosensitive film and the photosensitive resin composition of the present embodiment, the content of a mercapto compound (a compound having a mercapto group; for example, a mercapto group-containing hydrogen donor) may be 0.1 parts by mass or less, less than 0.1 parts by mass, 0.001 parts by mass or less, less than 0.001 parts by mass, or 0.0001 parts by mass or less, with respect to 100 parts by mass of the total amount of the component (A) and the component (B). The photosensitive film and the photosensitive resin composition of the present embodiment may not contain a mercapto compound (the above-described content may be substantially 0 parts by mass).

In the photosensitive film and the photosensitive resin composition of the present embodiment, the content of an acridine compound (a compound having an acridine ring) may be 0.1% by mass or less, less than 0.1% by mass, 0.01% by mass or less, or 0.001% by mass or less, on the basis of the total amount of the photosensitive film or the total amount (the total amount of solid contents) of the photosensitive resin composition. The photosensitive film and the photosensitive resin composition of the present embodiment may not contain an acridine compound (the above-described content may be substantially 0% by mass).

### <Photosensitive element>

A photosensitive element of the present embodiment includes a support and a photosensitive resin layer disposed on the support, and the photosensitive resin layer is the photosensitive film of the present embodiment. The photosensitive element of the present embodiment may include a protective layer disposed on the photosensitive resin layer. The photosensitive element of the present embodiment may include a cushion layer, an adhesive layer, a light-absorbing layer, a gas barrier layer, or the like. The photosensitive element may be in a sheet form, or may be in the form of a photosensitive element roll being wound around a core into a roll.

FIG. 1 is a schematic cross-sectional view illustrating an example of a photosensitive element. As illustrated in FIG. 1, a photosensitive element 1 includes a support (support film) 2, a photosensitive resin layer (photosensitive film) 3 disposed on the support 2, and a protective layer (protective film) 4 disposed on the photosensitive resin layer 3. The photosensitive resin layer 3 is composed of the photosensitive resin composition of the present embodiment.

The photosensitive element 1 can be obtained, for example, by the following procedure. First, the photosensitive resin layer 3 is formed on the support 2. The photosensitive resin layer 3 can be formed, for example, by drying a coating layer formed by applying a photosensitive resin composition containing an organic solvent. Next, the protective layer 4 is disposed on the photosensitive resin layer 3.

Each of the support and the protective layer may be a polymer film having heat resistance and solvent resistance, and may be a polyester film (such as a polyethylene terephthalate film), a polyolefin film (such as a polyethylene film or a polypropylene film), a hydrocarbon-based polymer (excluding a polyolefin film), or the like. The type of the film constituting the protective layer and the type of the film constituting the support may be the same as or different from each other.

The thickness of the support may be 1 µm or more, 5 µm or more, 10 µm or more, or 15 µm or more, from the viewpoint of easily suppressing the damage of the support when the support is peeled off from the photosensitive resin layer. The thickness of the support may be 100 µm or less, 50 µm or less, 30 µm or less, or 20 µm or less, from the viewpoint of suitably performing exposure in the case of exposure through the support.

The thickness of the protective layer may be 1 µm or more, 5 µm or more, 10 µm or more, or 15 µm or more, from the viewpoint of easily suppressing the damage of the protective layer when the photosensitive resin layer and the support are laminated on the base material while the protective layer is peeled off. The thickness of the protective layer may be 100 µm or less, 50 µm or less, or 30 µm or less, from the viewpoint of easily improving productivity.

### <Method for producing laminate>

A method for producing a laminate of the present embodiment includes a disposing step (photosensitive resin layer disposing step) of disposing a photosensitive resin layer on a base material (for example, substrate) by using the photosensitive film, the photosensitive element, or the photosensitive resin composition of the present embodiment, an exposure step of photo-curing (exposing) a part of the photosensitive resin layer, and a development step of removing at least a part of an uncured area (unexposed area) of the photosensitive resin layer to form a cured product pattern. A laminate of the present embodiment is obtained by the method for producing a laminate of the present embodiment, and may be a wiring board (for example, a printed circuit board). The laminate of the present embodiment may be an embodiment including a base material and a cured product pattern (cured product of the present embodiment) disposed on the base material.

The base material may have a recessed portion. The cross-sectional shape (the shape of the cross-section perpendicular to the lamination direction) of the recessed portion may be a circular shape (for example, a substantially true circle shape), a rectangular shape, a line shape (a straight line shape), or the like. The recessed portion of the base material may be a bottomed recessed portion. The diameter (for example, maximum diameter) or the depth (length in the lamination direction) of the recessed portion may be in the following ranges. The diameter of the recessed portion may be 10 µm or more, 30 µm or more, 50 µm or more, 80 µm or more, 100 µm or more, 120 µm or more, 150 µm or more, 180 µm or more, or 200 µm or more. The diameter of the recessed portion may be 500 µm or less, 400 µm or less, 300 µm or less, 250 µm or less, or 200 µm or less. From these viewpoints, the diameter of the recessed portion may be 10 to 500 µm. The depth of the recessed portion may be 1 µm or more, 3 µm or more, 5 µm or more, 6 µm or more, or 8 µm or more. The depth of the recessed portion may be 20 µm or less, 18 µm or less, 15 µm or less, 12 µm or less, 10 µm or less, or 8 µm or less. The depth of the recessed portion may be 1 to 20 µm.

In the disposing step, a photosensitive resin layer composed of the photosensitive resin composition of the present embodiment is disposed on a base material. For example, the photosensitive resin layer may be formed by removing the protective layer from the photosensitive element and then pressure-bonding the photosensitive resin layer of the photosensitive element to the base material while heating the photosensitive resin layer, and may be formed by applying the photosensitive resin composition onto the base material and drying the photosensitive resin composition. The method for producing a laminate of the present embodiment may be an embodiment in which the base material has a recessed portion having the above-described diameter (for example, a diameter of 500 µm or less) and at least a part of the photosensitive resin layer is disposed inside the recessed portion in the disposing step.

In the exposure step, a region other than a region of the photosensitive resin layer in which a mask is disposed may be exposed and photo-cured by irradiation with an active light ray in a state where the mask is disposed on the photosensitive resin layer, and a part of the photosensitive resin layer may be exposed and photo-cured by irradiation with an active light ray at a desired pattern by a direct writing exposure method such as an LDI exposure method or a DLP exposure method without using a mask. As the light source for the active light ray, an ultraviolet source or a visible light source may be used and examples thereof include a carbon arc lamp, a mercury vapor arc lamp, a highpressure mercury lamp, a xenon lamp, a gas laser (such as an argon laser), a solid-state laser (such as a YAG laser), and a semiconductor laser.

The development method in the development step may be, for example, wet development or dry development. The wet development can be performed using a developing solution suitable for the photosensitive resin composition, for example, by methods such as a dip method, a paddle method, a spray method, brushing, slapping, scrubbing, and dipping while shaking. The developing solution is appropriately selected in accordance with the configuration of the photosensitive resin composition, and may be an alkaline developing solution or an organic solvent developing solution.

The alkaline developing solution may be aqueous solutions containing bases such as alkali hydroxides such as hydroxides of lithium, sodium, or potassium; alkali carbonates such as carbonates or bicarbonates of lithium, sodium, potassium, or ammonium; alkali metal phosphates such as potassium phosphate and sodium phosphate; alkali metal pyrophosphate such as sodium pyrophosphate and potassium pyrophosphate; borax; sodium metasilicate; tetramethylammonium hydroxide; ethanolamine; ethylenediamine; diethylene triamine; 2-amino-2-hydroxymethyl-1,3-propanediol; 1,3-diamino-2-propanol; and morpholine.

The organic solvent developing solution may contain organic solvents such as 1,1,1-trichloroethane, N-methylpyrrolidone, N,N-dimethylformamide, cyclohexanone, methyl isobutyl ketone, and γ-butyrolactone.

The method for producing a laminate of the present embodiment may include a metal layer formation step of forming a metal layer on at least a part of a portion of the base material in which a cured product pattern is not formed, after the development step. The laminate of the present embodiment may be an embodiment including a base material, a cured product pattern (the cured product of the present embodiment) disposed on the base material, and a metal layer disposed on at least a part of a portion in the base material in which the cured product pattern is not formed.

The metal layer in the metal layer formation step may be, for example, a metal copper layer. The metal layer can be formed, for example, by performing a plating treatment. The plating treatment may be one or both of an electrolytic plating treatment and a non-electrolytic plating treatment.

The method for producing a laminate of the present embodiment may include a step of further curing a resist pattern by heating at 60 to 250°C or exposure at 0.2 to 10 J/cm² after the development step.

The method for producing a laminate of the present embodiment may include a step of removing the cured product pattern after the metal layer formation step. The cured product pattern can be removed, for example, using a strong alkaline aqueous solution by performing development such as a dipping method and a spraying method.

### Examples

Hereinafter, the present disclosure will be further specifically described by means of Examples; however, the present disclosure is not limited to these Examples.

### <Synthesis of binder polymer>

A solution (a) was prepared by mixing 27 parts by mass of methacrylic acid, 3 parts by mass of 2-hydroxyethyl methacrylate, 20 parts by mass of benzyl methacrylate, 50 parts by mass of styrene, and 0.9 parts by mass of azobisisobutyronitrile. A solution (b) was prepared by dissolving 0.5 parts by mass of azobisisobutyronitrile in 50 parts by mass of a mixed liquid of 30 parts by mass of methyl cellosolve and 20 parts by mass of toluene. After charging a mixed liquid of methyl cellosolve and toluene (methyl cellosolve : toluene = 45 : 38 (mass ratio)) in a flask equipped with a stirrer, a reflux condenser, a thermometer, a dropping funnel, and a nitrogen gas inlet tube, stirring was performed while blowing nitrogen gas into the flask, and the temperature was raised to 80°C. The solution (a) was added dropwise to the above-described flask over 4 hours at a constant dropwise addition rate, and then the solution in the flask was stirred at 80°C for 2 hours. Next, the solution (b) was added dropwise to the above-described flask over 10 minutes at a constant dropwise addition rate, and then the solution in the flask was stirred at 80°C for 3 hours. Further, the solution in the flask was heated to 95°C over 1 hour and kept at 90°C for 2 hours, stirring was then stopped, and the solution was cooled to room temperature (25°C), thereby obtaining a solution of a binder polymer A1. The non-volatile content (solid content) of the solution of the binder polymer A1 was 49% by mass.

The acid value of the binder polymer A1 was 176 mgKOH/g. The acid value was measured by the following procedure. First, the binder polymer A1 was weighed in an Erlenmeyer flask. Next, the binder polymer A1 was dissolved by addition of a mixed solvent (mass ratio: toluene/methanol = 70/30), and then a phenolphthalein solution was added as an indicator thereto. Then, the acid value was obtained by performing a titration using a 0.1 mol/L (N/10) potassium hydroxide solution (alcohol solution).

The weight average molecular weight (Mw) of the binder polymer A1 was 35000, and the number average molecular weight (Mn) thereof was 16000. The weight average molecular weight and the number average molecular weight were measured by gel permeation chromatography (GPC) under following conditions and were derived by conversion using a calibration curve of standard polystyrene.

### (GPC conditions)

Pump: Hitachi L-6000 type (manufactured by Hitachi, Ltd., trade name)
Column: Three columns below in total (manufactured by Showa Denko Materials Co., Ltd., trade name)
   Gelpack GL-R440
   Gelpack GL-R450
   Gelpack GL-R400M
Eluent: Tetrahydrofuran
Measurement temperature: 40°C
Injection amount: 200 µL
Flow rate: 2.05 mL/min
Detector: Hitachi L-3300 type RI (manufactured by Hitachi, Ltd., trade name)

A solution of a binder polymer A2 was obtained by performing the operation in the same manner as in the binder polymer A1, except that the monomers used in preparation of the solution (a) were changed to 27 parts by mass of methacrylic acid, 5 parts by mass of 2-hydroxyethyl methacrylate, 23 parts by mass of benzyl methacrylate, and 45 parts by mass of styrene. The non-volatile content (solid content) of the solution of the binder polymer A2 was 49% by mass. The acid value of the binder polymer A2 was 175 mgKOH/g, the weight average molecular weight (Mw) thereof was 35000, and the number average molecular weight (Mn) thereof was 16500.

### <Preparation of photosensitive resin composition>

A photosensitive resin composition was prepared by mixing each component shown in Table 1, 16 parts by mass of toluene, 6 parts by mass of methanol, and 10 parts by mass of acetone. Table 1 shows the blending amount (parts by mass) of each component, and the blending amount of the binder polymer and FA-321M(70) is the mass (solid content amount) of the non-volatile content. The details of respective components shown in Table 1 are as follows.

### (Photopolymerizable compound)

FA-321M(70): Propylene glycol monomethyl ether 70% solution of 2,2-bis(4-(methacryloxypolyethoxy)phenyl)propane (an adduct of an average of 10 mol of ethylene oxide) (EO-modified bisphenol A dimethacrylate, manufactured by Showa Denko Materials Co., Ltd., molecular weight: 804)
BP-2EM: 2,2-Bis(4-(methacryloxypolyethoxy)phenyl)propane (manufactured by Kyoeisha Chemical Co., Ltd., EO group: 2.6 (total value), molecular weight: 478)
FA-024M: (PO)(EO)(PO)-modified dimethacrylate (manufactured by Showa Denko Materials Co., Ltd., an adduct of an average of 6 mol of ethylene oxide and an average of 12 mol of propylene oxide (total value), molecular weight: 1114)
Trifunctional monomer: EO-modified trimethylolpropane trimethacrylate (manufactured by Showa Denko Materials Co., Ltd., trade name "FA-137M", EO group: 21 (total value))

### (Photopolymerization initiator)

BCIM: 2,2'-Bis(o-chlorophenyl)-4,4',5,5'-tetraphenyl-1,2'-biimidazole (manufactured by Hampford Research Inc.)

### (Sensitizer)

PZ-501D: 1-Phenyl-3-(4-methoxystyryl)-5-(4-methoxyphenyl)-pyrazoline (manufactured by NIPPON CHEMICAL WORKS CO., LTD.)
Diphenylanthracene: manufactured by Tokyo Chemical Industry Co., Ltd., trade name "9,10-Diphenylanthracene"
Dicyanodistyrylbenzene: 4'-(2-Cyanostyryl)-3-stilbenecarbonitrile

### (Other components)

TBC: 4-tert-Butylcatechol (manufactured by DIC Corporation, trade name "DIC-TBC")
LCV: Leuco crystal violet (manufactured by Yamada Chemical Co., Ltd.)
MKG: Malachite green (manufactured by OSAKA ORGANIC CHEMICAL INDUSTRY LTD.)
SF-808H: Mixture of carboxybenzotriazole, 5-amino-1H-tetrazole, and methoxypropanol (manufactured by SANWA KASEI CORP.)

### <Production of photosensitive element>

A polyethylene terephthalate film (manufactured by Toray Industries, Inc., trade name "FB-40") having a thickness of 16 µm was prepared as the support. The above-described photosensitive resin composition was applied onto the support to have an uniform thickness and then sequentially dried with a hot air convection drier set at 70°C and 110°C to form a photosensitive resin layer (photosensitive film; average thickness of ten places after drying: 19 µm). A polyethylene film (manufactured by TAMAPOLY CO., LTD., trade name "NF-15") as the protective layer was attached onto the photosensitive resin layer, thereby obtaining a photosensitive element including the support, the photosensitive resin layer, and the protective layer in this order.

### <Production of laminate>

A copper-clad laminate plate (substrate, manufactured by Showa Denko Materials Co., Ltd., trade name: MCL-E-67) including copper foils (thickness: 18 µm) disposed on both surfaces of a glass epoxy material was pickled, rinsed, and then dried with an air stream to obtain a base material. Next, this base material was heated to 80°C, and then the above-described photosensitive element was laminated so that the photosensitive resin layer was in contact with the copper surface while the protective layer was peeled off, thereby obtaining a laminate A including the base material (copper-clad laminate plate), the photosensitive resin layer, and the support in this order. The lamination was performed using a heat roll set at 110°C at a pressure-bonding pressure of 0.4 MPa and at a roll speed of 1.5 m/min.

A copper-clad laminate plate (substrate, manufactured by Showa Denko Materials Co., Ltd., trade name: MCL-E-67) including copper foils (thickness: 18 µm) disposed on both surfaces of a glass epoxy material was pickled, rinsed, and then dried with an air stream to obtain a base material. Next, a circular hole (cross-sectional shape: substantially true circle) having a diameter of 200 µm and a depth of 8 µm was formed at 25 places (array: 5 × 5, shortest distance between adjacent circular holes: 2 cm) on this base material. Next, the above-described photosensitive element was laminated by the same procedure as in the laminate A with respect to the surface of this base material on which the circular holes were formed, thereby obtaining a laminate B including the base material (copper-clad laminate plate), the photosensitive resin layer, and the support in this order.

### <Evaluation>

### (Sensitivity before temporal change)

After a 41-step tablet (manufactured by Showa Denko Materials Co., Ltd.) was placed on the support of the above-described laminate A, the photosensitive resin layer was exposed through the support at an exposure dose (irradiation energy dose) for 15 steps remaining on the 41-step tablet after the development by a direct writing exposure machine (manufactured by Via Mechanics, Ltd., trade name: DE-1UH) employing a blue-violet laser diode with a wavelength of 405 nm as the light source. The sensitivity (photosensitivity) was evaluated using the exposure dose (unit: mJ/cm²) at this time. Results are shown in Table 1. A smaller exposure dose indicates more satisfactory sensitivity.

### (Temporal stability of sensitivity)

The photosensitive elements were prepared and then stored at room temperature (25°C) for 7 days and 14 days, thereby obtaining two types of the photosensitive elements for temporal stability of sensitivity. A laminate a1 was obtained by the same procedure as in the above-described laminate A using the photosensitive element stored for 7 days. A laminate a2 was obtained by the same procedure as in the above-described laminate A using the photosensitive element stored for 14 days. The exposure dose (irradiation energy dose) was acquired in the same manner as in the above-described evaluation of sensitivity before temporal change using the laminate a1 and the laminate a2, and a difference between the exposure dose of the laminate a1 and the exposure dose of the laminate a2 was obtained. A case where the ratio of the exposure dose difference with respect to the exposure dose of the laminate a1 is 5% or less was evaluated as "A", and a case where the ratio thereof exceeds 5% was evaluated as "B". Results are shown in Table 1.

### (Minimum developing time)

The above-described laminate A was cut into a square shape (5 cm × 5 cm) and then the support was peeled off, thereby obtaining a test specimen. Then, an unexposed photosensitive resin layer in the test specimen was spray-developed at a pressure of 0.15 MPa using a 1% by mass sodium carbonate aqueous solution set at 30°C, and the shortest time that allowed the removal of the unexposed photosensitive resin layer to be visually confirmed was obtained as a minimum developing time (MD). A full-cone type nozzle was used. The distance between the above-described test specimen and the nozzle tip was 6 cm and the test specimen was disposed in such a manner that the center of the test specimen would coincide with the center of the nozzle. Results are shown in Table 1. A shorter minimum developing time (unit: second) indicates more satisfactory developability.

### (Resolution)

After a 41-step tablet (manufactured by Showa Denko Materials Co., Ltd.) was placed on the support of the above-described laminate A, exposure (drawing) was performed for the photosensitive resin layer through the support without Offset at an exposure dose (irradiation energy dose) for 15 steps remaining on the 41-step tablet after the development by a direct writing exposure machine (manufactured by Via Mechanics, Ltd., trade name: DE-1UH) employing a blue-violet laser diode with a wavelength of 405 nm as the light source using a drawing pattern with a line width (L)/space width (S) (hereinafter, referred to as "L/S") of 3x/x (x = 1 to 20, unit: µm, interval: 1 µm). Within 3 minutes after the exposure, post-exposure-bake (PEB) was performed using a heating oven under conditions of 80°C and 30 seconds.

After the exposure, the support was peeled off from the laminate A to expose the photosensitive resin layer, and unexposed areas were removed by spraying a 1% by mass sodium carbonate aqueous solution at 30°C for time twice the above-described minimum developing time. After the development, the resolution was evaluated by the minimum value (unit: µm) among the space width values of resist patterns in which space areas (unexposed areas) were removed without residues and line areas (exposed areas) were formed without meandering and defecting. Results are shown in Table 1. A smaller numerical value indicates more satisfactory resolution.

### (Adhesiveness)

After a 41-step tablet (manufactured by Showa Denko Materials Co., Ltd.) was placed on the support of the above-described laminate A, exposure (drawing) was performed for the photosensitive resin layer through the support without Offset at an exposure dose (irradiation energy dose) for 15 steps remaining on the 41-step tablet after the development by a direct writing exposure machine (manufactured by Via Mechanics, Ltd., trade name: DE-1UH) employing a blue-violet laser diode with a wavelength of 405 nm as the light source using a drawing pattern with an L/S of x/3x (x = 1 to 20, unit: µm, interval: 1 µm). Within 3 minutes after the exposure, post-exposure-bake (PEB) was performed using a heating oven under conditions of 80°C and 30 seconds.

After the exposure, the support was peeled off from the laminate A to expose the photosensitive resin layer, and unexposed areas were removed by spraying a 1% by mass sodium carbonate aqueous solution at 30°C for time twice the above-described minimum developing time. After the development, the adhesiveness was evaluated by the minimum value (unit: µm) among the line width values of resist patterns in which space areas (unexposed areas) were removed without residues and line areas (exposed areas) were formed without meandering and defecting. Results are shown in Table 1. A smaller numerical value indicates more satisfactory adhesiveness.

### (Followability)

Circular holes at ten places of the laminate B from the support side were observed using an optical microscope (KEYENCE CORPORATION, VK-8500). The area (Air void size, unit: µm²) of air bubbles generated between the circular holes and the cured product of the photosensitive resin layer was measured, and an average value of the circular holes at ten places was calculated. Results are shown in Table 1. A smaller area of air bubbles indicates excellent followability (circular hole followability).

**[Table 1]**

| | | Example | | | | | | Comparative Example | |
|---|---|---|---|---|---|---|---|---|---|
| | | 1 | 2 | 3 | 4 | 5 | 6 | 1 | 2 |
| Binder polymer | A1 | 56 | | | 56 | 56 | 56 | 56 | 56 |
| | A2 | | 56 | 56 | | | | | |
| Photopolymerizable compound | FA-321M(70) | 35 | 35 | 26 | 35 | 35 | 35 | 35 | 35 |
| | BP-2EM | 5 | 5 | 4 | 5 | 5 | 5 | 5 | 5 |
| | FA-024M | 4 | 4 | 6 | 4 | 4 | 4 | 4 | 4 |
| | Trifunctional monomer | | | 3 | | | | | |
| Photopolymerization initiator | B-CIM | 5 | 5 | 5 | 5 | 5 | 5 | 5 | 5 |
| Sensitizer | PZ-501D | 0.20 | 0.20 | 0.20 | 0.20 | 0.20 | 0.30 | | |
| | Diphenylanthracene | | | | | | | 0.65 | |
| | Dicyanodistyrylbenzene | | | | | | | | 0.65 |
| Other components | TBC | 0.010 | 0.010 | 0.010 | 0.015 | | 0.010 | | 0.015 |
| | LCV | 0.50 | 0.50 | 0.50 | 0.50 | 0.50 | 0.50 | 0.50 | 0.50 |
| | MKG | 0.010 | 0.010 | 0.010 | 0.010 | 0.010 | 0.010 | 0.010 | 0.010 |
| | SF-808H | 0.50 | 0.50 | 0.50 | 0.50 | 0.50 | 0.50 | 0.50 | 0.50 |
| Evaluation | Sensitivity before temporal change | 91 | 90 | 95 | 100 | 80 | 85 | 106 | 90 |
| | Temporal stability of sensitivity | A | A | A | A | B | A | B | B |
| | Minimum developing time | 17 | 15 | 11 | 17 | 16 | 17 | 16 | 16 |
| | Resolution | 10 | 12 | 12 | 9 | 14 | 10 | 12 | 18 |
| | Adhesiveness | 7 | 7 | 7 | 7 | 9 | 6 | 7 | 18 |
| | Followability | 12000 | 11000 | 12500 | 12100 | 12000 | 12500 | 22000 | 20000 |

### Reference Signs List

1: photosensitive element, 2: support, 3: photosensitive resin layer, 4: protective layer.

## Claims

1. A photosensitive film comprising: (A) a binder polymer; (B) a photopolymerizable compound; (C) a photopolymerization initiator; and (D) a pyrazoline compound, wherein
a thickness of the photosensitive film is 20 µm or less.

2. The photosensitive film according to claim 1, wherein the component (D) includes a compound having two or more aryl groups bonded to a pyrazoline ring.

3. The photosensitive film according to claim 1 or 2, wherein the component (D) includes a compound represented by General Formula (d1) below: 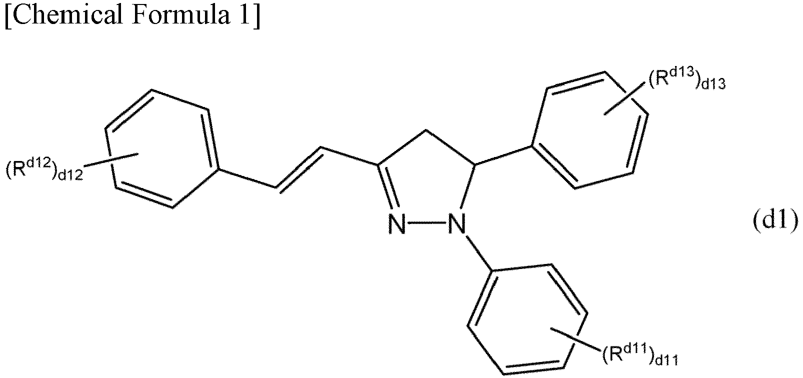 [in Formula (d1), R^{d11}, R^{d12}, and R^{d13} each independently represent an alkoxy group or an alkyl group, and d11, d12, and d13 each independently represent an integer of 0 to 5].

4. The photosensitive film according to any one of claims 1 to 3, wherein a content of the component (D) is 0.10 to 1.0 part by mass with respect to 100 parts by mass of the total amount of the component (A) and the component (B).

5. The photosensitive film according to any one of claims 1 to 4, wherein a content of the component (D) is 1.0 to 10 parts by mass with respect to 100 parts by mass of the total amount of the component (C) and the component (D).

6. The photosensitive film according to any one of claims 1 to 5, wherein a content of a monomer unit of hydroxyalkyl (meth)acrylate in the component (A) is 0.10 to 5.0% by mass on the basis of the total amount of monomer units constituting the component (A).

7. The photosensitive film according to any one of claims 1 to 6, wherein the component (A) has aryl (meth)acrylate and a styrene compound as monomer units.

8. The photosensitive film according to any one of claims 1 to 7, wherein a content of a monomer unit of a styrene compound in the component (A) is 40% by mass or more on the basis of the total amount of monomer units constituting the component (A).

9. The photosensitive film according to any one of claims 1 to 8, wherein a weight average molecular weight of the component (A) is 20000 to 50000.

10. The photosensitive film according to any one of claims 1 to 9, wherein the component (B) includes a bisphenol A-type (meth)acrylic acid compound.

11. The photosensitive film according to claim 10, wherein a content of the bisphenol A-type (meth)acrylic acid compound is 30 parts by mass or more with respect to 100 parts by mass of the total amount of the component (A) and the component (B).

12. The photosensitive film according to any one of claims 1 to 11, wherein the component (B) includes a (meth)acrylic acid compound having a polyoxyalkylene group.

13. The photosensitive film according to any one of claims 1 to 12, wherein a content of the component (B) is 30 to 60 parts by mass with respect to 100 parts by mass of the total amount of the component (A) and the component (B).

14. The photosensitive film according to any one of claims 1 to 13, further comprising a catechol compound.

15. A photosensitive element comprising: a support; and a photosensitive resin layer disposed on the support, wherein
the photosensitive resin layer is the photosensitive film according to any one of claims 1 to 14.

16. A method for producing a laminate, the method comprising:
a disposing step of disposing a photosensitive resin layer on a base material by using the photosensitive film according to any one of claims 1 to 14 or the photosensitive element according to claim 15;
a step of photo-curing a part of the photosensitive resin layer; and
a step of removing at least a part of an uncured area of the photosensitive resin layer to form a cured product pattern.

17. The method for producing a laminate according to claim 16, wherein the base material has a recessed portion having a diameter of 500 µm or less, and
at least a part of the photosensitive resin layer is disposed in the recessed portion in the disposing step.
